# EUROPEAN PATENT SPECIFICATION

(11) **EP 4 286 986 B1**
(45) Date of publication and mention of the grant of the patent: **04.11.2026**
(21) Application number: 23742696.0
(22) Date of filing: 04.01.2023
(51) Int. Cl.: G06F 1/16, H04M 1/02, F16C 11/04

(54) **ROTATING SHAFT MECHANISM, SUPPORT DEVICE AND FOLDING SCREEN APPARATUS**
DREHWELLENMECHANISMUS, STÜTZVORRICHTUNG UND FALTBILDSCHIRMVORRICHTUNG
MÉCANISME D'ARBRE ROTATIF, DISPOSITIF DE SUPPORT ET APPAREIL À ÉCRAN PLIABLE

(30) Priority: 18.01.2022 CN 202210057046; 08.04.2022 CN 202210366979
(43) Date of publication of application: 06.12.2023
(73) Proprietor: Honor Device Co., Ltd., Shenzhen, Guangdong 518040 (CN)
(72) Inventor: ZHANG, Yaolei, Shenzhen, Guangdong 518040 (CN); ZHOU, Guotong, Shenzhen, Guangdong 518040 (CN); YAN, Bin, Shenzhen, Guangdong 518040 (CN); ZHANG, Yihe, Shenzhen, Guangdong 518040 (CN)
(74) Representative: Gill Jennings & Every LLP
(86) International application number: PCT/CN2023/070520
(87) International publication number: WO 2023/138380

(56) References cited:
- EP-A1- 3 809 678
- EP-A2- 2 421 229
- WO-A1-2006/120300
- WO-A1-2020/210987
- CN-A- 113 067 924
- CN-A- 113 266 635
- CN-A- 113 315 860
- CN-A- 113 905 113
- JP-A- 2005 275 964
- KR-B1- 100 385 668
- US-A1- 2004 264 118
- US-A1- 2020 281 085
- US-A1- 2021 011 522
- US-A1- 2021 011 522
- US-A1- 2021 271 294
- US-B1- 6 831 229
- US-B2- 8 842 424

## Description

### TECHNICAL FIELD

The invention relates to the field of foldable screen device technologies, and in particular, to a rotating shaft mechanism, a support apparatus, and a foldable screen device.

### BACKGROUND

Currently, to resolve problems such as a large size and non-portability of a conventional flat panel terminal, a foldable screen device emerges. The foldable screen device includes housings on both sides and a rotating shaft mechanism connected between the housings on both sides. Inside the rotating shaft mechanism, a shaft cover covers back sides of a rotating shaft base and a moving part inside the rotating shaft mechanism. In a process of folding or unfolding the foldable screen device, the housings on both sides and the shaft cover overlap each other, to maintain an appearance of the foldable screen device. However, as the foldable screen device develops toward thinning, an overlap amount between the housings on both sides and the shaft cover is insufficient. Consequently, when the foldable screen device is in a folded state, the housings on both sides are separated from the shaft cover, and an internal moving part is exposed. This affects quality and the appearance of the foldable screen device.
US2021011522A1 describes a portable information device that includes a hinge device rotatably connecting one edge portions of a first chassis and a second chassis, a display, and a cover member covering a side of the hinge device. The hinge device connects the first chassis and the second chassis so as to be foldable from a usage form in which a top surface of the first chassis and a top surface of the second chassis are on substantially the same plane to a storage form in which the top surfaces of the first chassis and the second chassis face each other. The cover member is contained inside the first chassis and the second chassis in the usage form and covers a side of a gap formed by separation of the one edge portions of the first chassis and the second chassis in the storage form.
JP2005275964A describes an electronic device that displays information such as characters, images, and moving images on a display unit such as a liquid crystal display. WO2006120300A1 describes a hinge structure to be used in portable electronic devices, such as mobile stations, making it possible to rotate the first body part and the second body part of the device in relation to the axis of rotation of the hinge structure, the hinge structure comprising at least a hinge element which comprises a first hinge half and a second hinge half which are arranged to be movable in relation to each other by means of a pivot placed on the axis of rotation, and which hinge element is arranged to be connected by the first hinge half to the first body part of the device and by the second hinge half to the second body part. The hinge structure comprises a shield structure for shielding the back of the device, the shield structure being connected to the hinge element, and the shield structure being arranged to be movable in the direction perpendicular to the axis of rotation.
KR100385668B1 a case for a foldable multi-display device that connects multiple display panels to form a single large screen, but when unfolded, one side of the display panels contacts each other to minimize the non-display area, and when folded, covers the opening and the side of the display panel.
EP2421229A2 describes a mobile device that includes a first housing, a second housing, and a hinge assembly rotatably coupling the first housing to the second housing and enabling movement of the device between an open configuration and a closed configuration. When the device is in the open configuration, the first housing is planar with the second housing.
US8842424B2 describes apparatus including a cover; a first connection section; and a second connection section. The first connection section includes a first hinge connected to a first end of the cover. The first hinge is configured to pivotably connect the first end of the cover to a first housing section. The second connection section is connected to a second end of the cover. The second connection section is configured to connect the second end of the cover to a second housing section which is pivotably connected to the first housing section. The second connection section is configured to provide both rotational and longitudinal sliding motion of the second end of the cover on the second housing section.
US2004264118A1 describes a portable computer includes upper and lower sections that are pivotally attached, together with a hinge assembly extending outwardly from the pivoted edges of the section. When the upper and lower sections are pivoted open, the hinge assembly moves outward and downward to form a handle by which the computer is easily held and a stand for convenient placement of the computer on a horizontal surface.

### SUMMARY

The invention provides a rotating shaft mechanism as defined by claim 1, a support apparatus as defined by claim 14, and a foldable screen device as defined by claim 15, to resolve a problem of how to avoid exposing an internal moving part without affecting thinning of the foldable screen device.

According to a first aspect, a rotating shaft mechanism is provided as defined in claim 1.

In addition to the shaft cover and the rotating shaft base, the rotating shaft mechanism further includes the first swing arms and the first drive mechanisms. The first swing arms are configured to be fastened to a middle frame. When a user folds the middle frame of a foldable screen device, the first swing arm is a primary moving part. Each first drive mechanism is connected between a respective one of the first swing arms and the shaft cover. When rotating from the unfolded location to the folded location, the first swing arm drives, by using the first drive mechanism, the shaft cover to move toward the rotating shaft base. When a thickness of the rotating shaft mechanism in this embodiment of this application in an unfolded state is equal to a thickness of the rotating shaft mechanism in the conventional technology, and the foldable screen terminal is in a folded state, the shaft cover moves upward by a specific height relative to the rotating shaft base, and the shaft cover that moves upward may compensate for a gap between the shaft cover and an overlap part of the middle frame to a specific extent, to reduce a risk that the internal rotating shaft base and an internal moving part connected to the rotating shaft base are exposed. Therefore, this avoids exposing the internal moving part without affecting thinning of the foldable screen device.

Each first drive mechanism includes a respective second swing arm; each second swing arm is rotatably connected to the rotating shaft base, each first swing arm is drivably connected to a respective one of the second swing arms, and each second swing arm is drivably connected to the shaft cover; and when rotating from the unfolded location to the folded location, the respective first swing arm drives the respective second swing arm to rotate relative to the rotating shaft base, and further drives, by using the respective second swing arm, the shaft cover to move toward the rotating shaft base. In this way, revolution movement of the first swing arm is transmitted to the shaft cover by using the second swing arm, so that the shaft cover moves upward. In addition, because the second swing arm is constrained by a location of a rotating pair on the rotating shaft base, drive stability is good.

In a possible implementation of the first aspect, each first drive mechanism includes a first sliding groove and a first sliding member, and, for each first drive mechanism; one of the first sliding groove and the first sliding member is disposed on the respective first swing arm, the other of the first sliding groove and the first sliding member is disposed on the respective second swing arm, and the first sliding member is slidably connected in the first sliding groove; and the respective first swing arm is drivably connected to the second swing arm by using a sliding pair formed by the first sliding groove and the first sliding member. The structure is simple, and occupies small space and a small height, to facilitate miniaturization and thinning of the rotating shaft mechanism.

In a possible implementation of the first aspect, for each first drive mechanism, rotation axes of the respective second swing arm and the respective rotating shaft base are a first axis; the respective first sliding groove has a first end and a second end, and a distance from the first end to the first axis is less than a distance from the second end to the first axis; and when the respective first swing arm is at the unfolded location, a vertical distance from the first end to a foldable screen is greater than a vertical distance from the second end to the foldable screen, and when the respective first swing arm rotates from the unfolded location to the folded location, the respective first sliding member slides from the first end to the second end along the respective first sliding groove. In this way, when the first swing arm rotates from the unfolded location to the folded location, an angle by which the first swing arm drives the second swing arm to rotate relative to the rotating shaft base is less than a rotation angle of the first swing arm relative to the rotating shaft base.

In a possible implementation of the first aspect, each first drive mechanism further includes an actuating member; and the actuating member is fastened relative to the respective second swing arm, and the respective second swing arm is drivably connected to the shaft cover by using the actuating member. In this way, when driving the second swing arm to rotate relative to the rotating shaft base, the first swing arm further drives the actuating member to rotate relative to the rotating shaft base, to further drive, by using the actuating member, the shaft cover to move upward. In this embodiment, in a whole formed by the second swing arm and the actuating member, an end part drivably connected to the first swing arm is laid out on the second swing arm, and an end part drivably connected to the shaft cover is laid out on the actuating member. This avoids a case in which the end part drivably connected to the first swing arm and the end part drivably connected to the shaft cover are laid out on the second swing arm together, and can reduce structure complexity of the second swing arm.

In a possible implementation of the first aspect, a distance from an end part, that is on the respective second swing arm and that is drivably connected to the respective first swing arm, to a rotation center of the respective second swing arm is a first distance; an end part that is on the actuating member and that is drivably connected to the shaft cover is eccentrically disposed relative to the rotation center of the respective second swing arm, and a distance from the end part, that is on the actuating member and that is drivably connected to the shaft cover, to the rotation center of the respective second swing arm is a second distance; and the first distance is less than the second distance. In this way, when a rotation angle of the actuating member is the same as a rotation angle of the second swing arm, a length of a swing arm is reduced by using the actuating member, so that a height by which the actuating member can be used to drive the shaft cover to move upward is reduced. This helps reduce an overall height of the rotating shaft mechanism when the shaft cover is in the unfolded state, thereby facilitating thinning of the foldable screen device in the unfolded state.

In a possible implementation of the first aspect, each first drive mechanism further includes a second sliding groove and a second sliding member and, for each first drive mechanism; one of the second sliding groove and the second sliding member is disposed on the respective actuating member, the other of the second sliding groove and the second sliding member is disposed on the shaft cover, and the second sliding member is slidably connected in the second sliding groove; and the respective actuating member is drivably connected to the shaft cover by using a sliding pair formed by the second sliding groove and the second sliding member. The structure is simple, and occupies small space and a small height, to facilitate miniaturization and thinning of the rotating shaft mechanism.

In a possible implementation of the first aspect, the rotating shaft mechanism further includes two door plates and two second drive mechanisms, where each door plate is rotatably connected to a respective one of the first swing arms, and each second drive mechanism is connected between a respective one of the door plates and the rotating shaft base and, for each second drive mechanism; when rotating from the unfolded location to the folded location, the respective first swing arm drives, by using the second drive mechanism, an end that is of the respective door plate and that is close to the rotating shaft base to tilt toward a side away from the foldable screen relative to an end that is of the respective door plate and that is away from the rotating shaft base. In this way, when the first swing arm rotates to the folded location, an included angle between a surface that is of the door plate and that is used to dispose the foldable screen and a surface that is of the rotating shaft base and that is used to dispose the foldable screen is a first angle, and an included angle between a surface that is of the middle frame and that is used to dispose the foldable screen and the surface that is of the rotating shaft base and that is used to dispose the foldable screen is a second angle. The first angle is less than the second angle. In other words, when the first swing arm rotates from the unfolded location to the folded location, a rotation angle of the door plate relative to the rotating shaft base is greater than a rotation angle of the middle frame relative to the rotating shaft base. Because the middle frame is fastened to the first swing arm, the rotation angle of the middle frame relative to the rotating shaft base is equal to a rotation angle of the first swing arm relative to the rotating shaft base. In other words, the rotation angle of the door plate relative to the rotating shaft base is greater than the rotation angle of the first swing arm relative to the rotating shaft base. In this way, a third display area of the foldable screen may be folded into a water drop shape, to reduce an inward folding angle, reduce a probability that a crease occurs on the foldable screen, ensure a display effect of the foldable screen, and prolong a life span of the foldable screen.

In a possible implementation of the first aspect, each second drive mechanism includes a respective door plate swing arm, and the door plate swing arm is rotatably connected to the rotating shaft base; and a third sliding groove is disposed on the door plate, the door plate swing arm slidably penetrates into the third sliding groove, and when the respective first swing arm rotates from the unfolded location to the folded location, an angle by which the respective first swing arm drives the door plate swing arm to rotate relative to the rotating shaft base is greater than a rotation angle of the first swing arm relative to the rotating shaft base.

In a possible implementation of the first aspect, the rotating shaft mechanism further includes a synchronization mechanism; and the synchronization mechanism is connected between the two first swing arms, or the synchronization mechanism is connected between the second swing arms of the two first drive mechanisms.

In a possible implementation of the first aspect, the synchronization mechanism is connected between second swing arms of the two first drive mechanisms. There is sufficient space between the two second swing arms to facilitate mounting of the synchronization mechanism.

In a possible implementation of the first aspect, the synchronization mechanism is connected between two door plate swing arms.

In a possible implementation of the first aspect, the synchronization mechanism includes a drive slider, and the drive slider is located between the second swing arms of the two first drive mechanisms; the drive slider is slidably connected to the rotating shaft base in a length direction of the rotating shaft base, and the drive slider is drivably connected to the second swing arms of the two first drive mechanisms; and when rotating from the unfolded location to the folded location, either of the second swing arms of the two first drive mechanisms drives the drive slider to slide in the length direction of the rotating shaft base, and drives the other of the second swing arms to synchronously rotate from the unfolded location to the folded location. The synchronization mechanism occupies a small height, so that a thickness of the rotating shaft mechanism can be reduced, to facilitate thinning of the foldable screen device.

In a possible implementation of the first aspect, one of a spiral sliding groove and a slider is disposed on the drive slider, and the other of the spiral sliding groove and the slider is disposed on the second swing arm; and a center line of a spiral extension path of the spiral sliding groove is parallel to a slidable direction of the drive slider, and the slider is slidably disposed in the spiral sliding groove. The drivable connection manner between the drive slider and the second swing arm is a drivable connection obtained by using a structure including the spiral sliding groove and the slider. The structure is simple, and occupies small space, to facilitate a compact structure design of the rotating shaft mechanism.

In a possible implementation of the first aspect, the rotating shaft mechanism further includes two damping mechanisms.

Each damping mechanism is disposed between a respective one of the first swing arms and the rotating shaft base, or between the first sliding groove and the first sliding member of a respective one of the first drive mechanisms, or the damping mechanism is disposed between a respective one of the second swing arms and the rotating shaft base, or the damping mechanism is disposed between the second sliding groove and the second sliding member, or the damping mechanism is disposed between the third sliding groove and the door plate swing arm, or the damping mechanism is disposed between the door plate and the first swing arm.

In a possible implementation of the first aspect, an end surface of the first sliding groove of each of the first drive mechanisms, in a length direction of the rotating shaft base, is a friction surface; each damping mechanism is connected to a respective one of the first sliding members, and when sliding along the first sliding groove, the respective first sliding member drives the respective damping mechanism to move along the respective friction surface; each of the damping mechanisms includes a respective friction member and a respective elastic member, the friction member is located on a side faced by the respective friction surface, and the elastic member is configured to apply, to the friction member, elastic force pointing to the respective friction surface, so that the respective friction member abuts the respective friction surface. The structure is simple and easy to implement.

When rotating from the folded location to the unfolded location, each first swing arm drives, by using the first drive mechanism, the shaft cover to move away from the rotating shaft base. In this way, reset may be implemented, so that upward movement of the shaft cover during next folding is not affected.

In the first aspect, a limiting structure is disposed between the shaft cover and the rotating shaft base, and the limiting structure allows the shaft cover to move toward or away from the rotating shaft base in a thickness direction of the rotating shaft base, to prevent the shaft cover from moving along a plane perpendicular to the thickness direction of the rotating shaft base. In this way, limiting is performed by using the limiting structure, so that stability of upward movement or downward movement of the shaft cover can be ensured, to avoid the following case: The shaft cover is misaligned relative to the rotating shaft base, and cannot cover the rotating shaft base and a moving mechanism connected to the rotating shaft base.

According to a second aspect, a support apparatus as defined by claim 14 is provided.

Because the support apparatus provided in this embodiment of this application includes the rotating shaft mechanism described in any one of the foregoing technical solutions, the support apparatus and the rotating shaft mechanism can resolve a same technical problem and achieve a same effect. Details are not described herein again.

According to a third aspect, a foldable screen device as defined by claim 15 is provided.

Because the foldable screen device provided in this embodiment of this application includes the rotating shaft mechanism described in the foregoing technical solution, the foldable screen device and the rotating shaft mechanism can resolve a same technical problem and achieve a same effect. Details are not described herein again.

### BRIEF DESCRIPTION OF DRAWINGS

FIG. 1 is a three-dimensional view of a foldable screen device in an unfolded state according to some embodiments of this application;
FIG. 2 is a schematic diagram of a partial exploded structure of the foldable screen device shown in FIG. 1;
FIG. 3 is a schematic diagram of a structure of the foldable screen device shown in FIG. 1 in a folded state;
FIG. 4 is an assembly diagram of a primary middle frame, a secondary middle frame, a rotating shaft mechanism, and a foldable screen inside a foldable screen device in an unfolded state according to some embodiments of this application;
FIG. 5 is a schematic diagram of relative locations of a rotating shaft mechanism and a primary middle frame of a foldable screen device in a folded state according to some embodiments of this application;
FIG. 6 is a simplified diagram of a structure of a rotating shaft mechanism according to some other embodiments of this application;
FIG. 7 is a diagram of comparison between a foldable screen device, including the rotating shaft mechanism shown in FIG. 6, in a folded state and the foldable screen device shown in FIG. 5 in a folded state;
FIG. 8 is a simplified diagram of a structure of a rotating shaft mechanism according to some examples not falling in the scope of the claims;
FIG. 9 is a simplified diagram of a structure of a rotating shaft mechanism according to some examples not falling in the scope of the claims;
FIG. 10 is a simplified diagram of a structure of a rotating shaft mechanism according to some other embodiments of this application;
FIG. 11 is a simplified diagram of a structure of a rotating shaft mechanism according to some other embodiments of this application;
FIG. 12 is a simplified diagram of a structure of a rotating shaft mechanism according to some other embodiments of this application;
FIG. 13 is a simplified diagram of a structure of a rotating shaft mechanism according to some other embodiments of this application;
FIG. 14 is a simplified diagram of a structure of a rotating shaft mechanism according to some other embodiments of this application;
FIG. 15 is a simplified diagram of a structure of a rotating shaft mechanism according to some other embodiments of this application;
FIG. 16 is a simplified diagram of a structure of the rotating shaft mechanism shown in FIG. 15 in a folded state;
FIG. 17 is a three-dimensional view of a rotating shaft mechanism according to some embodiments of this application;
FIG. 18 is an enlarged view of an area I of the rotating shaft mechanism shown in FIG. 17;
FIG. 19 is a schematic diagram of a structure of the rotating shaft mechanism shown in FIG. 18 after two door plates are hidden;
FIG. 20 is a three-dimensional view of a rotating shaft base in the rotating shaft mechanism shown in FIG. 18 and FIG. 19;
FIG. 21 is an exploded view of the rotating shaft base shown in FIG. 20;
FIG. 22 is an assembly diagram of a first swing arm and a cross section of the rotating shaft base shown in FIG. 20 at a line A-A;
FIG. 23 is a schematic diagram of a structure of the rotating shaft mechanism shown in FIG. 22 in a folded state;
FIG. 24 is a schematic diagram of a structure of an actuating member in the rotating shaft mechanism shown in FIG. 19;
FIG. 25 is an assembly diagram of the actuating member shown in FIG. 24 and a second connecting piece in the rotating shaft base shown in FIG. 21;
FIG. 26 is a schematic diagram of a structure of a second swing arm in the rotating shaft mechanism shown in FIG. 19;
FIG. 27 is an assembly diagram of the assembly structure shown in FIG. 25 and the second swing arm shown in FIG. 26;
FIG. 28 is a schematic diagram of a cross-sectional structure of the rotating shaft mechanism shown in FIG. 19 at a line B-B;
FIG. 29 is a schematic diagram of a structure of the rotating shaft mechanism shown in FIG. 28 in a half folded state;
FIG. 30 is a schematic diagram of a structure of a shaft cover in the rotating shaft mechanism shown in FIG. 19;
FIG. 31 is a schematic diagram of a cross-sectional structure of the shaft cover shown in FIG. 30 at a line C-C;
FIG. 32 is a schematic diagram of an assembly structure of the shaft cover and the lift slider shown in FIG. 31 and a second sliding member on an actuating member;
FIG. 33 is a schematic diagram of a structure of the rotating shaft mechanism shown in FIG. 32 in a folded state;
FIG. 34 is a schematic diagram of a cross-sectional structure of the rotating shaft mechanism shown in FIG. 18 at a line D-D;
FIG. 35 is a schematic diagram of a structure of the rotating shaft mechanism shown in FIG. 18 in a folded state;
FIG. 36 is an exploded view of a synchronization mechanism, a second connecting piece, a second swing arm, and an actuating member in the rotating shaft mechanism shown in FIG. 19;
FIG. 37 is an assembly diagram of a synchronization mechanism, a second connecting piece, a second swing arm, and an actuating member in the rotating shaft mechanism shown in FIG. 36;
FIG. 38 is an assembly diagram of a damping mechanism, a first swing arm, and a second swing arm in the rotating shaft mechanism shown in FIG. 19;
FIG. 39 is an exploded view of a damping mechanism, a first swing arm, and a second swing arm in the rotating shaft mechanism shown in FIG. 38;
FIG. 40 is a schematic diagram of a structure of an area II in the rotating shaft mechanism shown in FIG. 17;
FIG. 41 is a schematic diagram of a structure of the rotating shaft mechanism shown in FIG. 40 after a base body and a second swing arm are hidden;
FIG. 42 is a schematic diagram of a cross-sectional structure of the rotating shaft mechanism shown in FIG. 40 at a line E-E; and
FIG. 43 is a schematic diagram of a structure of the rotating shaft mechanism shown in FIG. 42 in a half folded state.

### DESCRIPTION OF EMBODIMENTS

In embodiments of this application, the terms "first" and "second" are merely used for the purpose of description, and cannot be construed as an indication or implication of relative importance or an implicit indication of a quantity of indicated technical features. Therefore, features defined with "first" and "second" may explicitly or implicitly include one or more of the features.

In the embodiments of this application, the term "include", "comprise", or any other variant thereof is intended to cover non-exclusive inclusion, so that a process, method, article, or apparatus that includes a series of elements includes not only those elements but also other elements that are not explicitly listed, or includes elements inherent to such a process, method, article, or apparatus. Without further limitation, the element defined by the sentence "including a..." does not exclude that other identical elements also exist in the process, method, article, or apparatus including the element.

In the embodiments of this application, the term "drivable connection" means that movement of one of two connected parts may be transmitted to the other part. A connection manner between the two parts includes but is not limited to at least one of connection manners such as a rotatable connection, a slidable connection, a drivable connection through gear meshing, a drivable connection by using a sprocket, and a drivable connection by using a cam mechanism.

This application provides a foldable screen device. The foldable screen device may be user equipment (user equipment, UE), a terminal device (terminal), or the like. For example, the foldable screen device may be a mobile terminal or a fixed terminal, for example, a tablet computer (portable android device, PAD), a personal digital assistant (personal digital assistant, PDA), a handheld device with a wireless communication function, a computing device, an in-vehicle device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), or a wireless terminal in a smart home (smart home). A form of the foldable screen device is not specifically limited in the embodiments of this application.

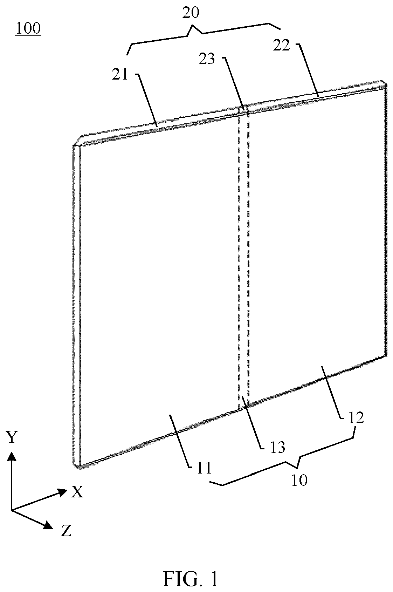

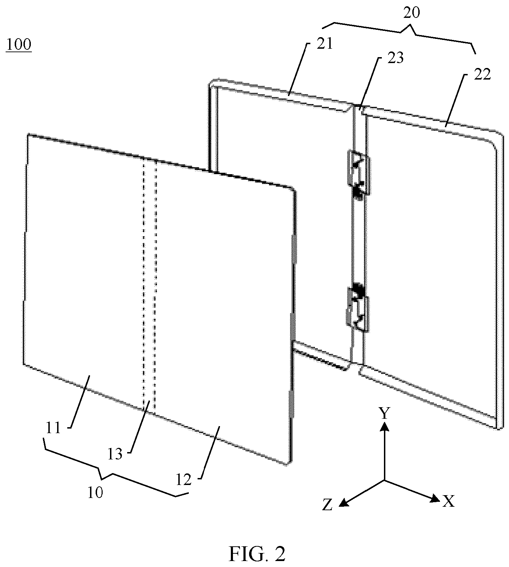

FIG. 1 is a three-dimensional view of a foldable screen device 100 in an unfolded state according to some embodiments of this application. FIG. 2 is a schematic diagram of a partial exploded structure of the foldable screen device 100 shown in FIG. 1. This embodiment and the following embodiments are described by using an example in which the foldable screen device 100 is a handheld device with a wireless communication function. The handheld device with a wireless communication function may be, for example, a mobile phone. The foldable screen device 100 is approximately in a shape of a rectangular flat panel in the unfolded state. For ease of description in the following embodiments, an XYZ coordinate system is established for the foldable screen device 100 in the unfolded state, a length direction of the foldable screen device 100 is defined as an X-axis direction, a width direction of the foldable screen device 100 is defined as a Y-axis direction, and a thickness direction of the foldable screen device 100 is defined as a Z-axis direction. It can be understood that the coordinate system of the foldable screen device 100 may be flexibly set based on an actual requirement. This is not specifically limited herein. In some other embodiments, the foldable screen device 100 may be alternatively in a shape of a square flat panel, a shape of a round flat panel, a shape of an elliptical flat panel, or the like.

The foldable screen device 100 includes a foldable screen 10 and a support apparatus 20.

The foldable screen 10 is configured to display information such as an image and a video. The foldable screen 10 may be an organic light-emitting diode (organic light-emitting diode, OLED) screen, a micro organic light-emitting diode (micro organic light-emitting diode) screen, a quantum dot light emitting diodes (quantum dot light emitting diodes, QLED) screen, a liquid crystal display (liquid crystal display, LCD), or the like.

The foldable screen 10 has a display area used to display image information, and the display area of the foldable screen 10 is exposed, to present information such as an image and a video to a user. The foldable screen 10 includes a first display area 11, a second display area 12, and a third display area 13, and the third display area 13 is connected between the first display area 11 and the second display area 12. In the foldable screen device 100 shown in FIG. 1, when the foldable screen 10 is in the unfolded state, the first display area 11, the third display area 13, and the second display area 12 are successively arranged in the X-axis direction. In this way, the foldable screen device 100 is horizontally folded. In some other embodiments, when the foldable screen 10 is in the unfolded state, the first display area 11, the third display area 13, and the second display area 12 may be successively arranged in the Y-axis direction. In this way, the foldable screen device 100 is vertically folded. When the foldable screen 10 is in the unfolded state, large-screen display can be implemented, to provide richer information for the user, and bring better user experience to the user.

At least the third display area 13 of the foldable screen 10 is a flexible screen structure. In this way, the third display area 13 may be bent and deformed under external force, so that the foldable screen 10 is folded from the unfolded state shown in FIG. 1 to a folded state. The first display area 11 and the second display area 12 of the foldable screen 10 each may be a flexible screen structure, or may be a rigid screen structure, or may be a partial flexible screen structure and a partial rigid screen structure. This is not specifically limited herein.

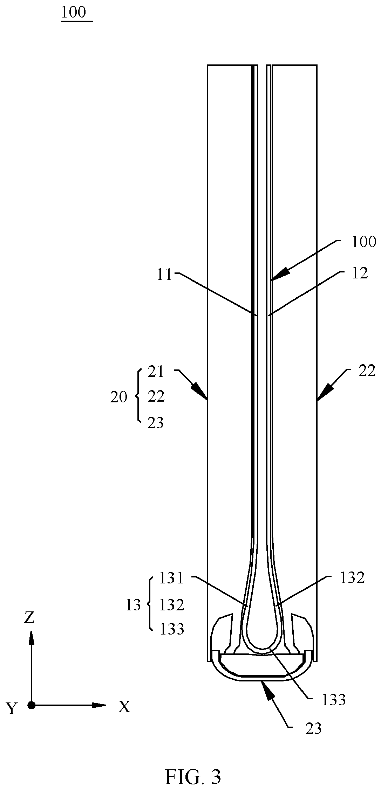

FIG. 3 is a schematic diagram of a structure of the foldable screen device 100 shown in FIG. 1 in a folded state. The foldable screen 10 in the foldable screen device 100 is also in the folded state. Specifically, when the foldable screen 10 is in the folded state, the first display area 11 and the second display area 12 of the foldable screen 10 are approximately parallel and opposite to each other. It should be noted that, if an included angle between the first display area 11 and the second display area 12 is within 30°, it can be considered that the first display area 11 and the second display area 12 are approximately parallel. That the first display area 11 and the second display area 12 are opposite to each other means that a display surface of the first display area 11 and a display surface of the second display area 12 face each other.

When the foldable screen 10 is in the folded state, still referring to FIG. 3, the third display area 13 is folded into a water drop form. In this form, the third display area 13 includes an arc segment 133, a first transition segment 131, and a second transition segment 132. The first transition segment 131 is connected between the arc segment 133 and the first display area 11. The second transition segment 132 is connected between the arc segment 133 and the second display area 12. A distance between an end that is of the first transition segment 131 and that is connected to the first display area 11 and an end that is of the second transition segment 132 and that is connected to the second display area 12 is a third distance, a distance between an end that is of the first transition segment 131 and that is connected to the arc segment 133 and an end that is of the second transition segment 132 and that is connected to the arc segment 133 is a fourth distance, and the fourth distance is greater than the third distance. It can be understood that, when the foldable screen device is in the folded state, the third display area 13 of the foldable screen 10 may be folded into another shape based on an actual requirement. This is not limited in this application.

When the foldable screen device 100 is in the folded state, still referring to FIG. 3, the support apparatus 20 protects the foldable screen 10 from the outside, and the foldable screen 10 is invisible to the user, so that the foldable screen 10 can be prevented from being scratched by a hard object. The foldable screen device is an inward foldable screen device, and a size of the foldable screen device 100 is reduced, so that the foldable screen device 100 is convenient to carry.

The support apparatus 20 is configured to bear the foldable screen 10. The support apparatus 20 includes a first housing (which may also be referred to as a primary housing) 21, a second housing (which may also be referred to as a secondary housing) 22, and a rotating shaft mechanism 23. The first housing 21 bears the first display area 11, and the second housing 22 bears the second display area 12. The rotating shaft mechanism 23 is connected between the first housing 21 and the second housing 22, and bears the third display area 13. The rotating shaft mechanism 23 is configured to implement revolution between the second housing 22 and the first housing 21, to support folding of the foldable screen 10 between the unfolded state and the folded state.

In the foregoing embodiment, optionally, the first housing 21 may include a middle frame and a back cover that are connected together. The first display area 11 of the foldable screen 10 is borne on the middle frame of the first housing 21, the back cover is located on a side that is of the middle frame and that is away from the first display area 11, and the back cover may be replaced with a display screen (for example, an LCD display screen). An accommodating cavity is formed between the middle frame and the back cover, and the accommodating cavity is configured to accommodate electronic components such as a mainboard, a camera module, and a battery. On this basis, the first housing 21 may be connected to the rotating shaft mechanism 23 by using the middle frame, or may be connected to the rotating shaft mechanism 23 by using the back cover. The following embodiments are described by using an example in which the first housing 21 is connected to the rotating shaft mechanism 23 by using the middle frame.

Similarly, the second housing 22 may also include a middle frame and a back cover that are connected together. The second display area 12 of the foldable screen 10 is borne on the middle frame of the second housing 22, the back cover is located on a side that is of the middle frame and that is away from the second display area 12, and the back cover may also be replaced with a display screen (for example, an LCD display screen). An accommodating cavity is formed between the middle frame and the back cover, and the accommodating cavity is configured to accommodate electronic components such as a sub-board, a loudspeaker module, an element, and a battery. On this basis, the second housing 22 may be connected to the rotating shaft mechanism 23 by using the middle frame, or may be connected to the rotating shaft mechanism 23 by using the back cover. The following embodiments are described by using an example in which the second housing 22 is connected to the rotating shaft mechanism 23 by using the middle frame.

It should be noted that, to distinguish between the middle frame of the first housing 21 and the middle frame of the second housing 22, in descriptions of the following embodiments, the middle frame of the first housing 21 is referred to as a primary middle frame, and has a reference numeral A in the accompanying drawings, and the middle frame of the second housing 22 is referred to as a secondary middle frame, and has a reference numeral B in the accompanying drawings.

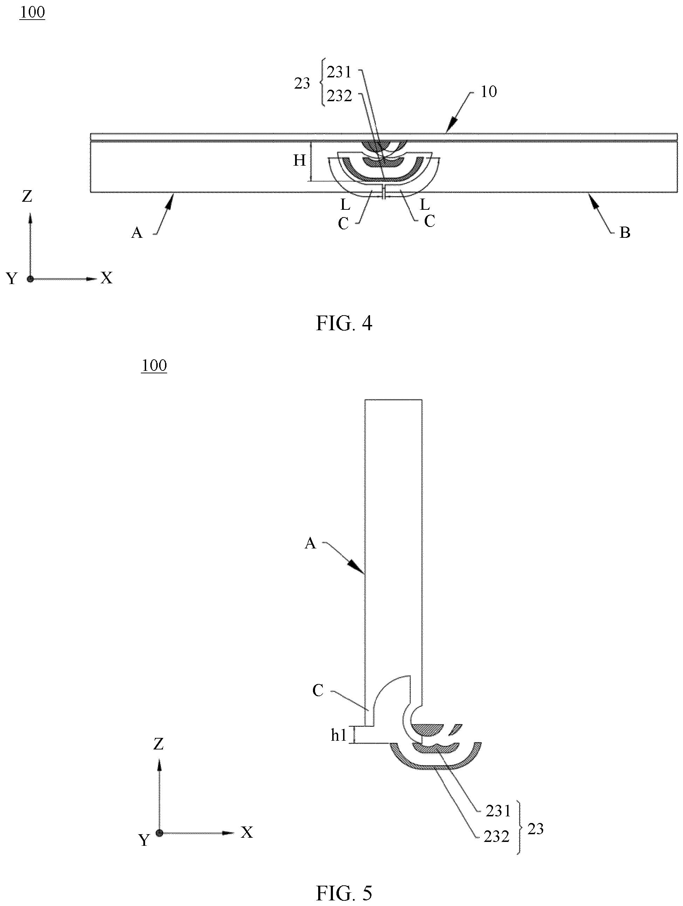

FIG. 4 is an assembly diagram of a primary middle frame A, a secondary middle frame B, a rotating shaft mechanism 23, and a foldable screen 10 inside a foldable screen device 100 in an unfolded state according to some embodiments of this application. The rotating shaft mechanism 23 includes a rotating shaft base 231 and a shaft cover 232.

The rotating shaft base 231 provides a location reference in the rotating shaft mechanism 23. The primary middle frame A and the secondary middle frame B are rotatably connected to the rotating shaft base 231, and the primary middle frame A and the secondary middle frame B can rotate relative to the rotating shaft base 231, so that the foldable screen device 100 moves between the unfolded state and the folded state. In addition, the rotating shaft base 231 is further configured to support a part of the foldable screen. Specifically, the rotating shaft base 231 is configured to support the third display area 13 of the foldable screen 10 in the foldable screen device shown in FIG. 3.

The shaft cover 232 is located on a back side of the rotating shaft base 231. It should be noted that the back side of the rotating shaft base 231 is a side that is of the rotating shaft base 231 and that faces away from the foldable screen 10. "Back side" used by another part in the rotating shaft mechanism 23 described in the following embodiments is a side that is of the described part and that faces away from the foldable screen 10. Details are not described again in the following embodiments.

The shaft cover 232 is used as an exterior part (namely, an externally visible part) of the rotating shaft mechanism 23, and is configured to cover the rotating shaft base 231 and a moving part (not shown in the figure) connected to the rotating shaft base 231 in the rotating shaft mechanism 23, to ensure an appearance of the foldable screen device, and prevent relative movement between the moving part and the rotating shaft base 231 in the rotating shaft mechanism 23 from being interfered with by an external environment.

Generally, the shaft cover 232 is fixedly connected to the rotating shaft base 231. The connection manner is stable and easy to implement. In addition, relative locations of the shaft cover 232 and the rotating shaft base 231 are fixed. In a process of folding the foldable screen device, the shaft cover 232 always covers back sides of the rotating shaft base 231 and the moving part connected to the rotating shaft base 231. Therefore, relative movement between the moving part and the rotating shaft base 231 in the rotating shaft mechanism 23 can be effectively prevented from being interfered with by the external environment.

Based on the foregoing descriptions, the shaft cover 232 is used as an exterior part of the rotating shaft mechanism 23. To ensure an appearance of the foldable screen device in a process of moving between the unfolded state and the folded state, in some embodiments, still referring to FIG. 4, the primary middle frame A and the secondary middle frame B each have an overlap part C. The overlap part C may also be disposed on the back cover of each of the first housing 21 and the second housing 22. There is a specific overlap amount L between the overlap part C and the shaft cover 232. When the foldable screen device moves from the unfolded state to the folded state, the overlap amount L gradually decreases. When the foldable screen device moves from the folded state to the unfolded state, the overlap amount L gradually increases. In the process in which the foldable screen device moves between the unfolded state and the folded state, a minimum overlap amount is an overlap amount existing when the foldable screen device is in the folded state, and the minimum overlap amount needs to be greater than or equal to 0 millimeters (mm), to avoid generating a step difference between the overlap part C and the shaft cover 232, and avoid exposing the moving part inside the rotating shaft mechanism 23. However, as the foldable screen device gradually develops toward lightening and thinning, a thickness H of the rotating shaft mechanism 23 gradually decreases, and the overlap amount L between the overlap part C and the shaft cover 232 is insufficient. Consequently, when the foldable screen device is in the folded state, FIG. 5 is a schematic diagram of relative locations of a rotating shaft mechanism 23 and a primary middle frame A of a foldable screen device 100 in a folded state according to some embodiments of this application, and it can be seen from FIG. 5 that the overlap part C is separated from the shaft cover 232, a gap with a height h1 exists in the Z-axis direction, and the internal rotating shaft base 231 and the internal moving part connected to the rotating shaft base 231 are exposed. This affects the appearance and quality of the foldable screen device 100.

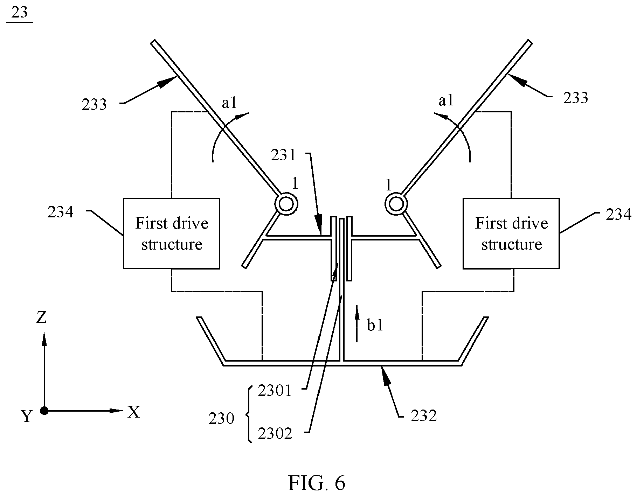

To resolve the foregoing problem, FIG. 6 is a simplified diagram of a structure of a rotating shaft mechanism 23 according to some other embodiments of this application. In this embodiment, the rotating shaft mechanism 23 includes a rotating shaft base 231, a shaft cover 232, a first swing arm 233, and a first drive mechanism 234.

Functions of the rotating shaft base 231 and the shaft cover 232 are the same as functions of the rotating shaft base 231 and the shaft cover 232 in the foregoing embodiment. The rotating shaft base 231 may have a plurality of shapes, and the rotating shaft base 231 may be an integral structure, or may be formed by assembling a plurality of parts. The shaft cover 232 may be semicircular, arc-shaped, or U-shaped, or may be in another shape. Materials of the rotating shaft base 231 and the shaft cover 232 include but are not limited to metal and plastic. The shaft cover 232 is located on a back side of the rotating shaft base 231.

The first swing arm 233 may also be referred to as a primary swing arm. The first swing arm 233 is rotatably connected (which may also be referred to as a hinged or revolution connection) to the rotating shaft base 231 by using a rotating pair 1, and the first swing arm 233 is configured to be fastened to the middle frame (including the primary middle frame A and the secondary middle frame B). When the user folds the foldable screen device 100, the first swing arm 233 moves with the middle frame, and the first swing arm 233 may be understood as a primary moving part of the rotating shaft mechanism 23. In some embodiments, referring to FIG. 6, there are two first swing arms 233, the two first swing arms 233 are symmetrically disposed on two opposite sides of the rotating shaft base 231, and the two first swing arms 233 are respectively configured to be fastened to the primary middle frame A and the secondary middle frame B. The two first swing arms 233 are both rotatably connected to the rotating shaft base 231, and the two first swing arms 233 can rotate between an unfolded location and a folded location relative to the rotating shaft base 231. When the two first swing arms 233 are at the unfolded location, the rotating shaft mechanism 23 is in the unfolded state, and the foldable screen device on which the rotating shaft mechanism 23 is mounted is in the unfolded state. When the two first swing arms 233 are at the folded location, the rotating shaft mechanism 23 is in the folded state, and the foldable screen device on which the rotating shaft mechanism 23 is mounted is in the folded state.

The first drive mechanism 234 is connected between the first swing arm 233 and the shaft cover 232, and when rotating from the unfolded location to the folded location in a direction a1, the first swing arm 233 may drive, by using the first drive mechanism 234, the shaft cover 232 to move toward the rotating shaft base 231 in a direction b1. That the shaft cover 232 moves toward the rotating shaft base 231 means that a movement direction of the shaft cover 232 makes a distance between the shaft cover 232 and the rotating shaft base 231 smaller. The rotating shaft base 231 is used as a location reference. Based on an orientation relationship shown in FIG. 6, movement of the shaft cover 232 toward the rotating shaft base 231 is upward movement. Upward movement of the shaft cover 232 may be an upward movement in the Z-axis direction. In some other embodiments, an upward movement track of the shaft cover 232 may also tilt by a specific angle relative to the Z-axis direction, for example, tilt by 5°, 6°, 7°, 8°, 9°, or 10°. It should be noted that, when the tilt angle of the upward movement track of the shaft cover 232 relative to the Z-axis direction is less than 5°, it can be considered that the shaft cover 232 moves upward in the Z-axis direction. In this embodiment of this application, an example in which upward movement of the shaft cover 232 is upward movement in the Z-axis direction is used for description. This should not be construed as a special limitation on this application.

In some embodiments, referring to FIG. 6, there may be two first drive mechanisms 234. The two first drive mechanisms 234 are respectively connected between the two first swing arms 233 and the shaft cover 232. When rotating from the unfolded location to the folded location, the two first swing arms 233 drive, by using the two first drive mechanisms 234, the shaft cover 232 to move upward. In this way, upward movement of the shaft cover 232 is smooth, tilt is not prone to occur, and a problem such as jamming is avoided.

In some other embodiments, there may be one first drive mechanism 234, and the one first drive mechanism 234 is connected between one of the two first swing arms 233 and the shaft cover 232. In this way, when rotating from the unfolded location to the folded location, the two first swing arms 233 may still drive, by using the one first drive mechanism 234, the shaft cover 232 to move toward the rotating shaft base 231. The rotating shaft mechanism 23 has a simple composition structure, low costs, and high assembly efficiency.

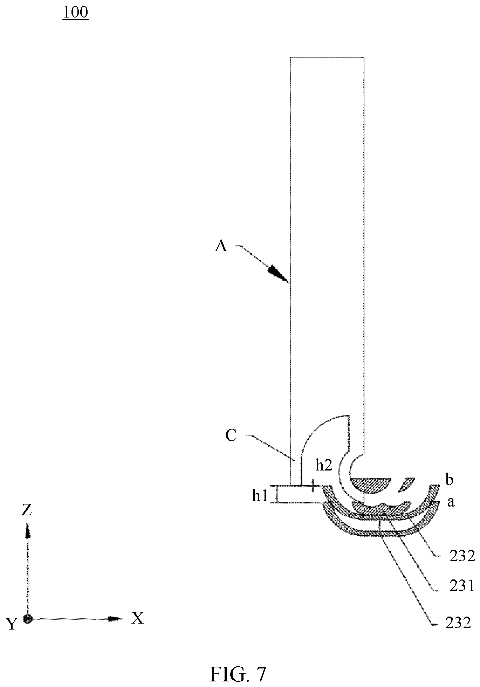

Based on the descriptions in the foregoing embodiment, in addition to the shaft cover 232 and the rotating shaft base 231, the rotating shaft mechanism 23 provided in this embodiment of this application further includes the first swing arm 233 and the first drive mechanism 234. The first swing arm 233 is configured to be fastened to the middle frame (including the primary middle frame A and the secondary middle frame B). When the user folds the middle frame of the foldable screen device 100, the first swing arm 233 is a primary moving part. The first drive mechanism 234 is connected between the first swing arm 233 and the shaft cover 232. When rotating from the unfolded location to the folded location, the first swing arm 233 may drive, by using the first drive mechanism 234, the shaft cover 232 to move upward. When a thickness of the rotating shaft mechanism 23 in this embodiment of this application in the unfolded state is equal to a thickness of the rotating shaft mechanism 23 in the foldable screen terminal 100 shown in FIG. 4-FIG. 5, and the foldable screen terminal 100 is in the folded state, FIG. 7 is a diagram of comparison between a foldable screen device 100, including the rotating shaft mechanism 23 shown in FIG. 6, in a folded state and the foldable screen device 100 shown in FIG. 5 in a folded state, and sizes, shapes, and relative locations of the rotating shaft bases 231 and the middle frames (only the primary middle frame A is displayed in the figure) in the two foldable screen devices 100 are the same, and locations thereof in FIG. 7 overlap. The shaft cover 232 of the foldable screen device 100 shown in FIG. 5 is at a location a, and the shaft cover 232 of the foldable screen device 100 including the rotating shaft mechanism 23 shown in FIG. 6 is at a location b, where the location b is higher than the location a. A gap between the overlap part C and the shaft cover 232 of the foldable screen device 100 shown in FIG. 5 is h1, and a gap between the overlap part C and the shaft cover 232 of the foldable screen device 100 including the rotating shaft mechanism 23 shown in FIG. 6 is h2, where h2 is less than h1. It can be learned that the shaft cover 232 that moves upward may compensate for the gap between the shaft cover 232 and the overlap part C of the middle frame to a specific extent, to reduce a risk that the internal rotating shaft base 231 and the internal moving part connected to the rotating shaft base 231 are exposed.

In some embodiments, h2 is approximately 0 or less than 0. It should be noted that, that h2 is less than 0 indicates that there is an overlap amount between the shaft cover 232 and the overlap part C. In this way, the gap between the shaft cover 232 and the overlap part C of the middle frame is effectively compensated for, to reduce, as much as possible, the risk that the internal rotating shaft base 231 and the internal moving part connected to the rotating shaft base 231 are exposed.

In some embodiments, when rotating from the folded location to the unfolded location in a direction opposite to the direction a1, the first swing arm 233 may drive, by using the first drive mechanism 234, the shaft cover 232 to move away from the rotating shaft base 231 in a direction opposite to the direction b1. That the shaft cover 232 moves away from the rotating shaft base 231 means that a movement direction of the shaft cover 232 makes a distance between the shaft cover 232 and the rotating shaft base 231 larger. The rotating shaft base 231 is used as a location reference. Based on an orientation relationship shown in FIG. 6, movement of the shaft cover 232 away from the rotating shaft base 231 is downward movement. In this way, reset may be implemented, so that upward movement of the shaft cover 232 during next folding is not affected.

In the foregoing embodiment, downward movement of the shaft cover 232 may also be downward movement in a -Z-axis direction, where the -Z-axis direction is a direction opposite to the Z-axis direction. In some other embodiments, a downward movement track of the shaft cover 232 may also tilt by a specific angle relative to the -Z-axis direction, for example, tilt by 5°, 6°, 7°, 8°, 9°, or 10°. It should be noted that, when the tilt angle of the downward movement track of the shaft cover 232 relative to the -Z-axis direction is less than 5°, it can be considered that the shaft cover 232 moves downward in the -Z-axis direction. The following embodiments are described by using an example in which downward movement of the shaft cover 232 is downward movement in the -Z-axis direction.

To ensure reliability of upward movement and the downward movement of the shaft cover 232, in some embodiments, referring back to FIG. 6, there is a limiting structure 230 between the shaft cover 232 and the rotating shaft base 231, and the limiting structure 230 allows the shaft cover 232 to move toward or away from the rotating shaft base 231 in a thickness direction (namely, the Z-axis direction) of the rotating shaft base 231, to prevent the shaft cover 232 from moving along a plane (namely, an XY plane) perpendicular to the thickness direction of the rotating shaft base 231. In this way, limiting is performed by using the limiting structure 230, so that stability of upward movement or downward movement of the shaft cover 232 can be ensured, to avoid the following case: The shaft cover 232 is misaligned relative to the rotating shaft base 231, and cannot cover the rotating shaft base 231 and a moving mechanism connected to the rotating shaft base 231.

In some embodiments, still referring to FIG. 6, the limiting structure 230 may include a limiting sliding groove 2301 and a limiting sliding member 2302. The limiting sliding groove 2301 is disposed on the rotating shaft base 231, and the limiting sliding member 2302 is disposed on the shaft cover 232. In some other embodiments, the limiting sliding member 2302 is disposed on the rotating shaft base 231, the limiting sliding groove 2301 is disposed on the shaft cover 232, the limiting sliding groove 2301 extends in the Z-axis direction, and the limiting sliding member 2302 is disposed in the limiting sliding groove 2301, and can slide along the limiting sliding groove 2301. The limiting sliding groove 2301 and the limiting sliding member 2302 form a sliding constraint, so that the shaft cover 232 slides relative to the rotating shaft base 231 in the Z-axis direction. The structure is simple and easy to implement. In some other embodiments, the limiting structure 230 may include a guide rail and a slider that is slidably connected to the guide rail, or may include a limiting hole and a limiting bar that slidably penetrates into the limiting hole. This is not limited herein.

The first drive mechanism 234 has a plurality of structure forms. For example, the first drive mechanism 234 is a connecting rod between the first swing arm 233 and the shaft cover 232. For another example, the first drive mechanism 234 is a sliding pair connected between the first swing arm 233 and the shaft cover 232, provided that when rotating between the unfolded location and the folded location, the first swing arm 233 can drive, by using the first drive mechanism 234, the shaft cover 232 to move upward/downward.

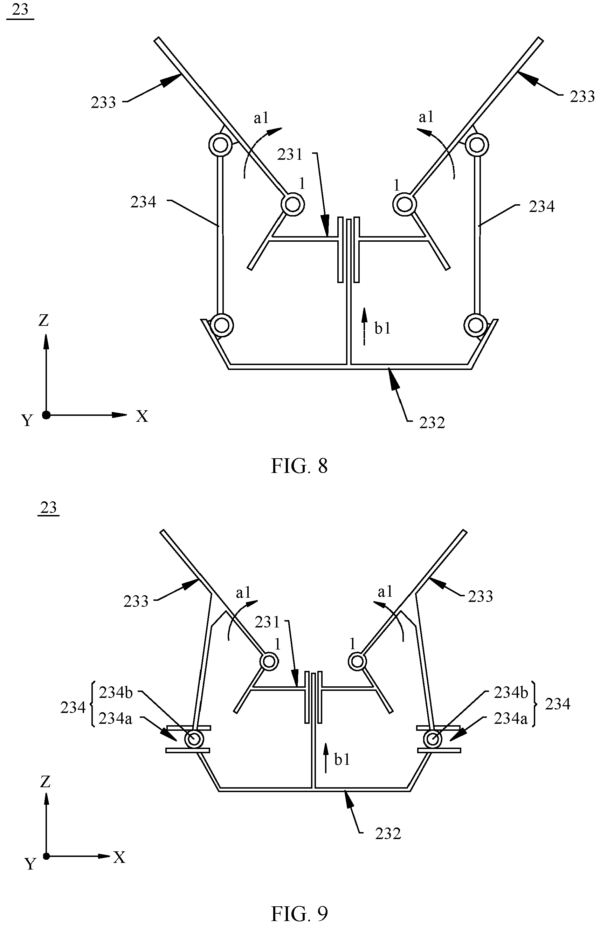

For example, FIG. 8 is a simplified diagram of a structure of a rotating shaft mechanism 23 according to some examples not falling in the scope of the claims. In this example, the first drive mechanism 234 is a connecting rod, one end of the connecting rod is rotatably connected to the first swing arm 233, and the other end of the connecting rod is rotatably connected to the shaft cover 232. When rotating from the unfolded location to the folded location in the direction a1, the first swing arm 233 may drive, by using the connecting rod, the shaft cover 232 to move toward the rotating shaft base 231 in the direction b1. The first drive mechanism 234 has a simple structure, low assembly difficulty, and high assembly efficiency.

For another example, FIG. 9 is a simplified diagram of a structure of a rotating shaft mechanism 23 according to some other examples not falling in the scope of the claims. In this example, the first drive mechanism 234 is a sliding pair. Optionally, referring to FIG. 9, the sliding pair includes a sliding groove 234a and a sliding member 234b. A structure form of the sliding member 234b includes but is not limited to a slider, a sliding rod, a roller, a rolling rod, a rolling shaft, or a rolling drum. The sliding member 234b is fastened to the first swing arm 233, and the sliding groove 234a is fastened to the shaft cover 232. In some other examples, the sliding member 234b may be fastened to the shaft cover 232, and the sliding groove 234a is fastened to the first swing arm 233. The sliding member 234b is slidably connected in the sliding groove 234a. In this way, the sliding groove 234a and the sliding member 234b form a sliding pair. When the first swing arm 233 rotates from the unfolded location to the folded location in the direction a1, the sliding member 234b drives the sliding groove 234a upward, and slides along the sliding groove 234a, thereby driving the shaft cover 232 to move toward the rotating shaft base 231 in the direction b1. The first drive mechanism 234 has a simple structure, low assembly difficulty, and high assembly efficiency. It should be noted that the sliding pair in this embodiment is not limited to a sliding groove and a sliding member, and may be a guide rail and a slider. This is not limited in this application.

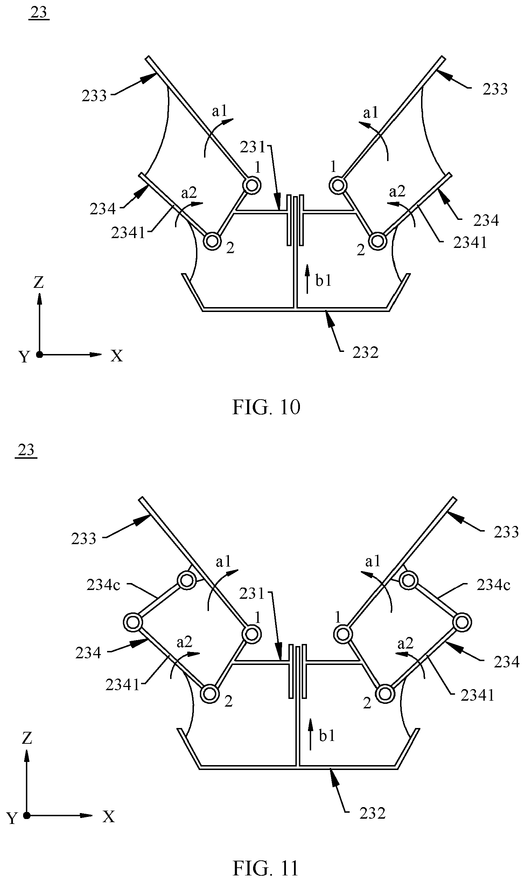

For another example, FIG. 10 is a simplified diagram of a structure of a rotating shaft mechanism 23 according to some other embodiments of this application. In this embodiment, the first drive mechanism 234 includes a second swing arm 2341. The second swing arm 2341 may also be referred to as a secondary swing arm. The second swing arm 2341 is rotatably connected to the rotating shaft base 231 by using a rotating pair 2, and the first swing arm 233 is drivably connected to the second swing arm 2341. When rotating from the unfolded location to the folded location in the direction a1, the first swing arm 233 can drive the second swing arm 2341 to rotate relative to the rotating shaft base 231. On this basis, the second swing arm 2341 is further drivably connected to the shaft cover 232. When rotating from the unfolded location to the folded location in the direction a1, the first swing arm 233 can further drive, by using the second swing arm 2341, the shaft cover 232 to move upward. In this way, revolution movement of the first swing arm 233 is transmitted to the shaft cover 232 by using the second swing arm 2341, so that the shaft cover 232 moves upward. In addition, because the second swing arm 2341 is constrained by a location of the rotating pair 2 on the rotating shaft base 231, drive stability is good.

When the foldable screen device is in the unfolded state, an overall height of the rotating shaft mechanism 23 is a key factor that affects the thickness of the foldable screen device. When the foldable screen device is in the unfolded state, the overall height of the rotating shaft mechanism 23 is affected by a thickness of the rotating shaft base 231, a thickness of the shaft cover 232, and an amount by which the shaft cover 232 moves upward in the process of moving from the unfolded state to the folded state. When the thickness of the rotating shaft base 231 and the thickness of the shaft cover 232 remain unchanged, if the amount by which the shaft cover 232 moves upward in the process of moving from the unfolded state to the folded state is smaller, a smaller overall thickness of the rotating shaft mechanism 23 may be designed, to further facilitate thinning of the foldable screen device in the unfolded state.

To meet a thinning design requirement of the foldable screen device, in some embodiments, the first swing arm 233 and the second swing arm 2341 are located on a same side of the rotating shaft base 231. In this way, a rotation direction of the second swing arm 2341 relative to the rotating shaft base 231 is the same as a rotation direction of the first swing arm 233 relative to the rotating shaft base 231. It should be noted that, if rotation directions of two parts in this embodiment of this application are the same, it indicates that the two parts that are drivably connected both rotate in a clockwise direction or in a counterclockwise direction from a same perspective. For the first swing arm 233 and the second swing arm 2341 that are drivably connected together, the rotation direction of the second swing arm 2341 is the same as the rotation direction of the first swing arm 233. Specifically, from the perspective shown in FIG. 10, a rotation direction al of a first swing arm 233 on the left is a clockwise direction, a second swing arm 2341 on the left is drivably connected to the first swing arm 233 on the left, a rotation direction of the second swing arm 2341 on the left is a direction a2, and the direction a2 is also a clockwise direction. A rotation direction a1 of a first swing arm 233 on the right is a counterclockwise direction, a second swing arm 2341 on the right is drivably connected to the first swing arm 233 on the right, and a rotation direction a2 of the second swing arm 2341 on the right is also a counterclockwise direction. Therefore, rotation directions in the direction a2 and the direction a1 are the same. On this basis, when the first swing arm 233 rotates from the unfolded location to the folded location, an angle by which the first swing arm 233 drives the second swing arm 2341 to rotate relative to the rotating shaft base 231 is less than a rotation angle of the first swing arm 233 relative to the rotating shaft base 231. In some embodiments, when the first swing arm 233 rotates from the unfolded location to the folded location, the rotation angle of the first swing arm 233 relative to the rotating shaft base 231 may be 90°. On this basis, the rotation angle of the second swing arm 2341 relative to the rotating shaft base 231 may be 75°, 80°, 85°, or the like. This is not limited in this application. It should be noted that, when the first swing arm 233 rotates from the unfolded location to the folded location, the rotation angle of the first swing arm 233 relative to the rotating shaft base 231 may be designed as another angle based on a form. This is not specifically limited herein. In this way, a drive angle is reduced by using the second swing arm 2341. Compared with a solution in which the first swing arm 233 is used to directly drive the shaft cover 232 to move upward, a height by which the second swing arm 2341 with a small rotation angle is used to drive the shaft cover 232 to move upward is small. This helps reduce an overall height of the rotating shaft mechanism 23 in the unfolded state, thereby facilitating thinning of the foldable screen device 100 in the unfolded state.

In some embodiments, the first swing arm 233 may be drivably connected to the second swing arm 2341 by using a connecting rod, or may be drivably connected to the second swing arm 2341 by using a sliding pair. This is not limited herein.

For example, FIG. 11 is a simplified diagram of a structure of a rotating shaft mechanism 23 according to some other embodiments of this application. In this embodiment, the first drive mechanism 234 includes a first connecting rod 234c, and the first swing arm 233 is drivably connected to the second swing arm 2341 by using the first connecting rod 234c. Specifically, one end of the first connecting rod 234c is rotatably connected to the first swing arm 233, and the other end of the first connecting rod 234c is rotatably connected to the second swing arm 2341. When rotating from the unfolded location to the folded location in the direction a1, the first swing arm 233 may drive, by using the first connecting rod 234c, the second swing arm 2341 to rotate relative to the rotating shaft base 231 in the direction a2. A revolution axis of the first swing arm 233 on the rotating shaft base 231 is not collinear with a revolution axis of the second swing arm 2341 on the rotating shaft base 231. The rotating shaft base 231, the first swing arm 233, the first connecting rod 234c, and the second swing arm 2341 form a hinged four-bar linkage mechanism. The hinged four-bar linkage mechanism has a degree of freedom of 1, a unique movement manner, and good stability. In addition, each bar length of the hinged four-bar linkage mechanism is properly designed. Therefore, when the rotating shaft mechanism 23 moves from the unfolded state to the folded state, the rotation angle of the second swing arm 2341 relative to the rotating shaft base 231 is less than the rotation angle of the first swing arm 233 relative to the rotating shaft base 231. The structure is simple and easy to implement.

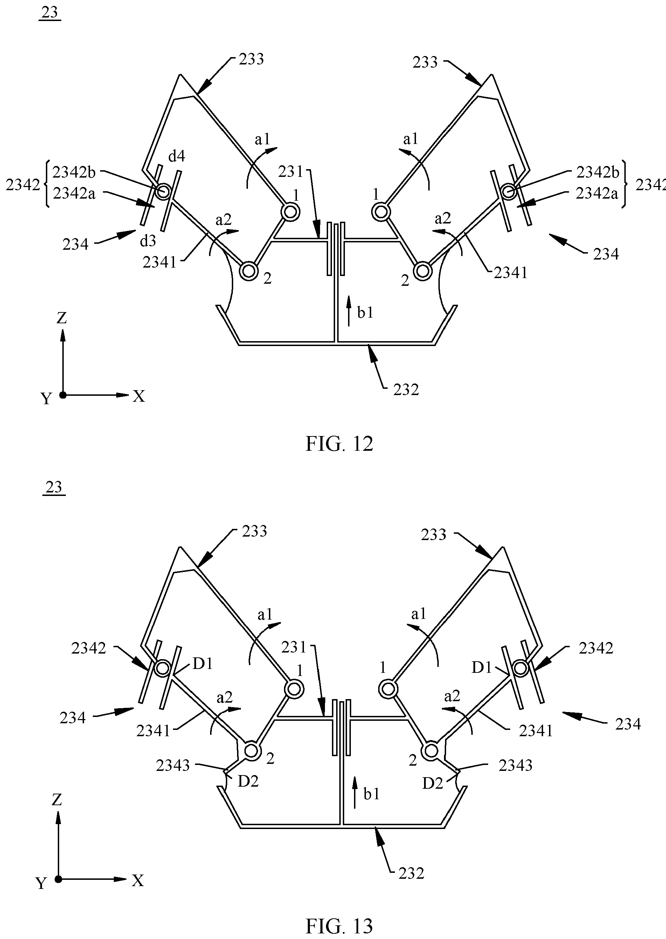

For another example, FIG. 12 is a simplified diagram of a structure of a rotating shaft mechanism 23 according to some other embodiments of this application. In this embodiment, the first drive mechanism 234 includes a sliding pair 2342, and the first swing arm 233 is drivably connected to the second swing arm 2341 by using the sliding pair 2342. In some embodiments, still referring to FIG. 12, the sliding pair 2342 includes a first sliding groove 2342a and a first sliding member 2342b. The first sliding groove 2342a is disposed on the second swing arm 2341. A structure form of the first sliding member 2342b includes but is not limited to a slider, a sliding rod, a roller, a rolling rod, a rolling shaft, or a rolling drum. The first sliding member 2342b is disposed on the first swing arm 233. In some other embodiments, the first sliding groove 2342a may be disposed on the first swing arm 233, and the first sliding member 2342b is disposed on the second swing arm 2341. The first sliding member 2342b is slidably connected in the first sliding groove 2342a. In this way, the first swing arm 233 is drivably connected to the second swing arm 2341 by using a sliding pair formed by the first sliding groove 2342a and the first sliding member 2342b. When rotating from the unfolded location to the folded location in the direction a1, the first swing arm 233 may drive the first sliding member 2342b upward by using the first sliding groove 2342a, so that the second swing arm 2341 rotates relative to the rotating shaft base 231 in the direction a2, and the first sliding member 2342b slides in the first sliding groove 2342a. A revolution axis of the first swing arm 233 on the rotating shaft base 231 is not collinear with a revolution axis of the second swing arm 2341 on the rotating shaft base 231. The rotating shaft base 231, the first swing arm 233, the sliding pair 2342, and the second swing arm 2341 form a slider-crank linkage mechanism. The slider-crank linkage mechanism has a degree of freedom of 1, a unique movement manner, and good stability. In addition, the structure is simple, and occupies small space and a small height, to facilitate miniaturization and thinning of the rotating shaft mechanism 23.

It can be understood that the sliding pair 2342 in the foregoing embodiment does not merely include a sliding groove and a sliding member, and may include a guide rail and a slider. This is not specifically limited in this application.

It should be noted that the following embodiments are described on the basis that the first swing arm 233 is drivably connected to the second swing arm 2341 by using the sliding pair 2342. This should not be construed as a special limitation on this application.

In some embodiments, referring to FIG. 12, rotation axes of the second swing arm 2341 and the rotating shaft base 231 are a first axis (namely, an axis of the rotating pair 2). The first sliding groove 2342a has a first end d3 and a second end d4, and a distance from the first end d3 to the first axis is less than a distance from the second end d4 to the first axis. When the first swing arm 233 is at the unfolded location, a vertical distance from the first end d3 to the foldable screen is greater than a vertical distance from the second end d4 to the foldable screen. In other words, the first sliding groove 2342a tilts toward the foldable screen from the first end d3 to the second end d4. In addition, when the first swing arm 233 rotates from the unfolded location to the folded location, the first sliding member 2342b slides from the first end d3 to the second end d4 along the first sliding groove 2342a. In this way, when the rotating shaft mechanism 23 moves from the unfolded state to the folded state, the rotation angle of the second swing arm 2341 relative to the rotating shaft base 231 is less than the rotation angle of the first swing arm 233 relative to the rotating shaft base 231.

In some embodiments, FIG. 13 is a simplified diagram of a structure of a rotating shaft mechanism 23 according to some other embodiments of this application. In this embodiment, the first drive mechanism 234 further includes an actuating member (also referred to as a crank actuating member) 2343. The actuating member 2343 is fastened relative to the second swing arm 2341. Specifically, the actuating member 2343 and the second swing arm 2341 may be two independent structural members that are fastened together through welding, clamping, threaded connection, bonding, or the like. Alternatively, the actuating member 2343 and the second swing arm 2341 may be an integral structural member, that is, the actuating member 2343 and the second swing arm 2341 are integrally formed. This is not specifically limited in this application. The second swing arm 2341 is drivably connected to the shaft cover 232 by using the actuating member 2343. In this way, when driving the second swing arm 2341 to rotate relative to the rotating shaft base 231, the first swing arm 233 further drives the actuating member 2343 to rotate relative to the rotating shaft base 231, to further drive, by using the actuating member 2343, the shaft cover 232 to move upward. In this embodiment, in a whole formed by the second swing arm 2341 and the actuating member 2343, an end part drivably connected to the first swing arm 233 is laid out on the second swing arm 2341, and an end part drivably connected to the shaft cover 232 is laid out on the actuating member 2343. This avoids a case in which the end part drivably connected to the first swing arm 233 and the end part drivably connected to the shaft cover 232 are laid out on the second swing arm 2341 together, and can reduce structure complexity of the second swing arm 2341.

Based on the foregoing embodiment, to further meet the thinning design requirement of the foldable screen device, in some embodiments, still referring to FIG. 13, a distance from an end part D1, that is on the second swing arm 2341 and that is drivably connected to the first swing arm 233, to a rotation center (namely, a center of the rotating pair 2) of the second swing arm 2341 is a first distance, an end part D2 that is on the actuating member 2343 and that is drivably connected to the shaft cover 232 is eccentrically disposed relative to the rotation center of the second swing arm 2341, and a distance from the end part D2, that is on the actuating member 2343 and that is drivably connected to the shaft cover 232, to the rotation center of the second swing arm 2341 is a second distance. The first distance is less than the second distance. In this way, when a rotation angle of the actuating member 2343 is the same as a rotation angle of the second swing arm 2341, a length of a swing arm is reduced by using the actuating member 2343, so that a height by which the actuating member 2343 can be used to drive the shaft cover 232 to move upward is reduced. This helps reduce an overall height of the rotating shaft mechanism 23 when the shaft cover 232 is in the unfolded state, thereby facilitating thinning of the foldable screen device 100 in the unfolded state.

In some embodiments, the actuating member 2343 may be drivably connected to the shaft cover 232 by using a connecting rod, or may be drivably connected to the shaft cover 232 by using a sliding pair. This is not limited herein.

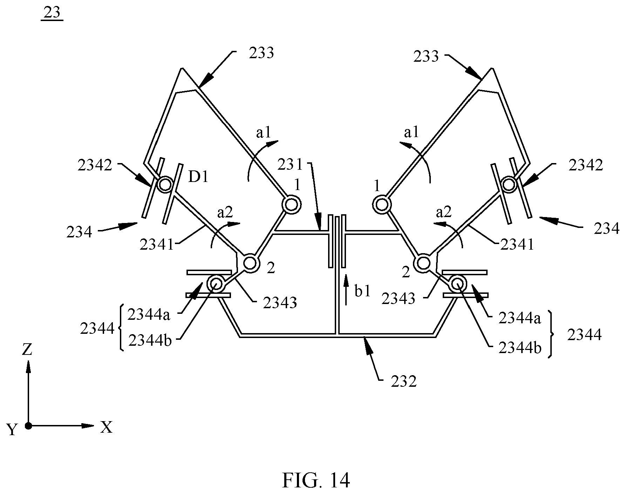

For example, FIG. 14 is a simplified diagram of a structure of a rotating shaft mechanism 23 according to some other embodiments of this application. In this embodiment, the first drive mechanism 234 further includes a sliding pair 2344, and the actuating member 2343 is drivably connected to the shaft cover 232 by using the sliding pair 2344. In some embodiments, still referring to FIG. 14, the sliding pair 2344 includes a second sliding groove 2344a and a second sliding member 2344b. The second sliding groove 2344a is disposed on the shaft cover 232. A structure form of the second sliding member 2344b includes but is not limited to a slider, a sliding rod, a roller, a rolling rod, a rolling shaft, or a rolling drum. In this way, the second sliding member 2344b is an eccentric block, an eccentric rod, an eccentric wheel, an eccentric shaft, or an eccentric circle relative to the rotation center of the second swing arm 2341. The second sliding member 2344b is disposed on the actuating member 2343. In some other embodiments, the second sliding groove 2344a may be disposed on the actuating member 2343, and the second sliding member 2344b is disposed on the shaft cover 232. The second sliding member 2344b is slidably connected in the second sliding groove 2344a. In this way, the actuating member 2343 is drivably connected to the shaft cover 232 by using a sliding pair formed by the second sliding groove 2344a and the second sliding member 2344b. When rotating with the second swing arm 2341, the actuating member 2343 may drive the second sliding groove 2344a upward by using the second sliding member 2344b, so that the shaft cover 232 moves upward in the direction b1. The structure is simple, and occupies small space and a small height, to facilitate miniaturization and thinning of the rotating shaft mechanism 23.

It can be understood that the sliding pair 2344 in the foregoing embodiment does not merely include a sliding groove and a sliding member, and may include a guide rail and a slider. This is not specifically limited in this application.

It can be learned from the foregoing descriptions that the first drive mechanism 234 has a plurality of structure forms. The following embodiments are further described based on the first drive mechanism 234 shown in FIG. 14. This should not be construed as a special limitation on this application.

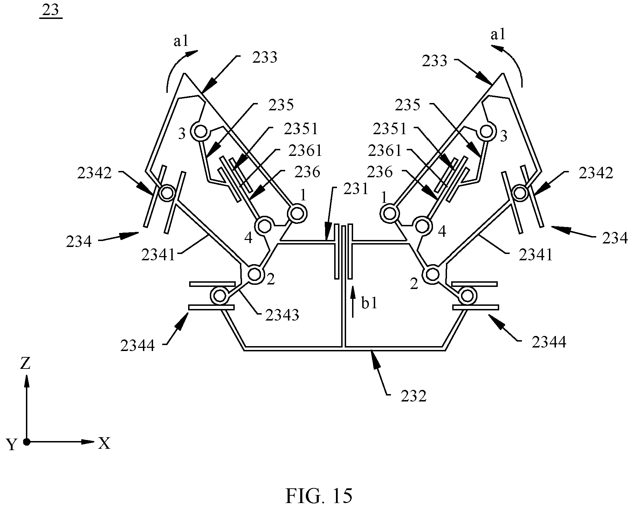

In some embodiments, FIG. 15 is a simplified diagram of a structure of a rotating shaft mechanism 23 according to some other embodiments of this application. A difference between the rotating shaft mechanism 23 in this embodiment and the rotating shaft mechanism 23 shown in FIG. 14 is as follows: In this embodiment, the rotating shaft mechanism 23 further includes a door plate 235 and a second drive mechanism 236.

In the foldable screen device, the door plate 235 is located between the middle frame (including the primary middle frame and the secondary middle frame) and the rotating shaft base 231. The door plate 235 is configured to support a part of the foldable screen 10. Specifically, the door plate 235 is configured to support the display areas 131 and 132 on both sides of the third display area 13 of the foldable screen 10 in the foldable screen device shown in FIG. 3. When the foldable screen terminal is in the unfolded state, a surface that is of the middle frame and that is used to dispose the foldable screen 10, a surface that is of the door plate 235 and that is used to dispose the foldable screen 10, and a surface that is of the rotating shaft base 231 and that is used to dispose the foldable screen 10 are approximately coplanar.

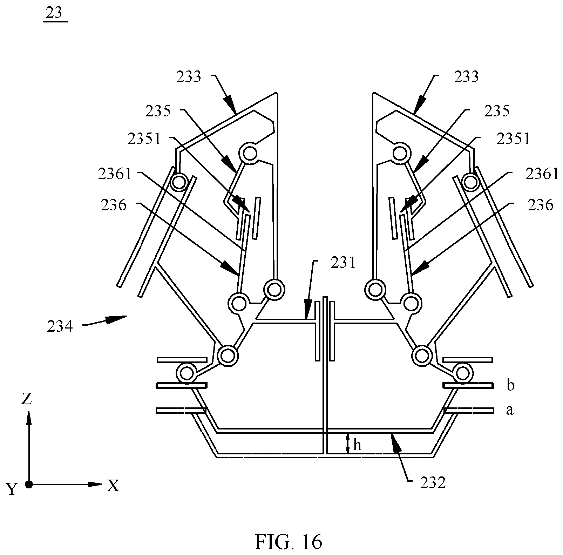

The door plate 235 is rotatably connected to the first swing arm 233 by using a rotating pair 3. The second drive mechanism 236 is connected between the door plate 235 and the rotating shaft base 231. When rotating from the unfolded location to the folded location in the direction a1, the first swing arm 233 drives, by using the second drive mechanism 236, an end that is of the door plate 235 and that is close to the rotating shaft base 231 to tilt toward a side away from the foldable screen relative to an end that is of the door plate 235 and that is away from the rotating shaft base 231. In this way, when the first swing arm 233 rotates to the folded location, FIG. 16 is a simplified diagram of a structure of the rotating shaft mechanism 23 shown in FIG. 15 in a folded state, the shaft cover 232 moves upward by a height h, an included angle between the surface that is of the door plate 233 and that is used to dispose the foldable screen 10 and the surface that is of the rotating shaft base 231 and that is used to dispose the foldable screen 10 is a first angle, and an included angle between the surface that is of the middle frame and that is used to dispose the foldable screen 10 and the surface that is of the rotating shaft base 231 and that is used to dispose the foldable screen 10 is a second angle. The first angle is less than the second angle. In other words, when the first swing arm 233 rotates from the unfolded location to the folded location, a rotation angle of the door plate 233 relative to the rotating shaft base 231 is greater than a rotation angle of the middle frame relative to the rotating shaft base 231. Because the middle frame is fastened to the first swing arm 233, the rotation angle of the middle frame relative to the rotating shaft base 231 is equal to the rotation angle of the first swing arm 233 relative to the rotating shaft base 231. In other words, the rotation angle of the door plate 233 relative to the rotating shaft base 231 is greater than the rotation angle of the first swing arm 233 relative to the rotating shaft base 231. When the rotation angle of the first swing arm 233 is 90°, the rotation angle of the door plate 233 may be 100°, 105°, 102°, 110°, or the like. This is not specifically limited herein. In this way, a third display area of the foldable screen may be folded into a water drop shape, to reduce an inward folding angle, reduce a probability that a crease occurs on the foldable screen, ensure a display effect of the foldable screen, and prolong a life span of the foldable screen.

The second drive mechanism 236 has a plurality of structure forms.

For example, the second drive mechanism 236 is a connecting rod connected between the door plate 235 and the rotating shaft base 231.

For another example, still referring to FIG. 15, the second drive mechanism 236 includes a door plate swing arm 2361. The door plate swing arm 2361 is rotatably connected to the rotating shaft base 231 by using a rotating pair 4, and a revolution axis of the rotating pair 4 is not collinear with a revolution axis of the rotating pair 1. A third sliding groove 2351 is disposed on the door plate 235, and the door plate swing arm 2361 slidably penetrates into the third sliding groove 2351. When rotating from the unfolded location to the folded location in the direction a1, the first swing arm 233 drives the door plate swing arm 2361 to rotate relative to the rotating shaft base 231, and enables the door plate swing arm 2361 to slide in the third sliding groove 2351. A rotation direction of the door plate swing arm 2361 is the same as a rotation direction of the first swing arm 233. On this basis, when the first swing arm 233 rotates from the unfolded location to the folded location, an angle by which the first swing arm 233 drives the door plate swing arm 2361 to rotate relative to the rotating shaft base 231 is greater than the rotation angle of the first swing arm 233 relative to the rotating shaft base 231. That is, when the first swing arm 233 rotates from the unfolded location to the folded location, the angle by which the first swing arm 233 drives the door plate 235 to rotate relative to the rotating shaft base 231 is greater than the rotation angle of the first swing arm 233 relative to the rotating shaft base 231. In this way, the third display area of the foldable screen may be folded into a water drop shape. The structure is simple, and occupies a small volume and a small height, so that a volume and a height of the rotating shaft mechanism can be reduced.

In the foregoing embodiments, a plurality of embodiments of this application are described by using a simplified diagram of a structure. The following describes a specific structure of the rotating shaft mechanism 23 in detail with reference to a three-dimensional view.

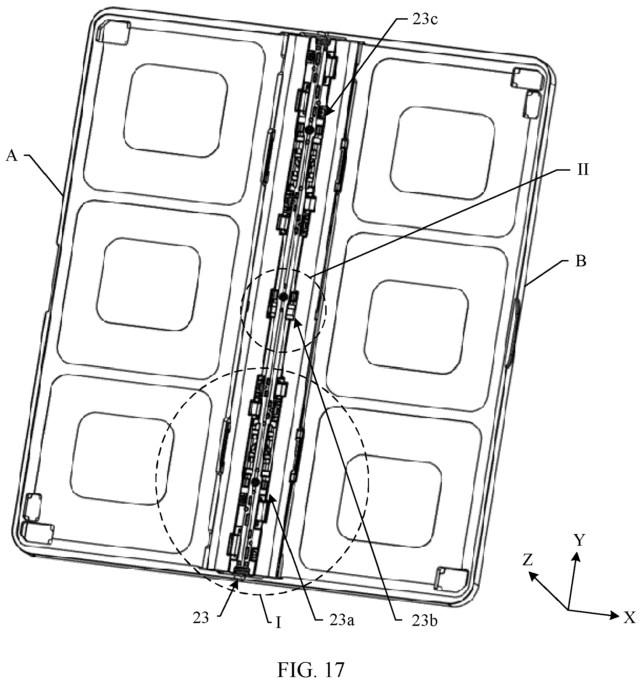

FIG. 17 is a three-dimensional view of a rotating shaft mechanism 23 according to some embodiments of this application. In this embodiment, the rotating shaft mechanism 23 is in an unfolded state. The rotating shaft mechanism 23 includes a first rotating shaft part 23a, a second rotating shaft part 23b, and a third rotating shaft part 23c. The first rotating shaft part 23a, the second rotating shaft part 23b, and the third rotating shaft part 23c are successively disposed in a length direction (namely, a Y-axis direction) of the rotating shaft mechanism 23. The following first describes a specific structure of the first rotating shaft part 23a.

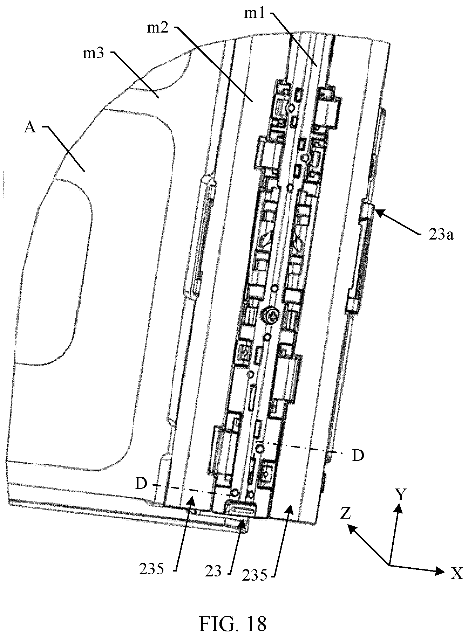

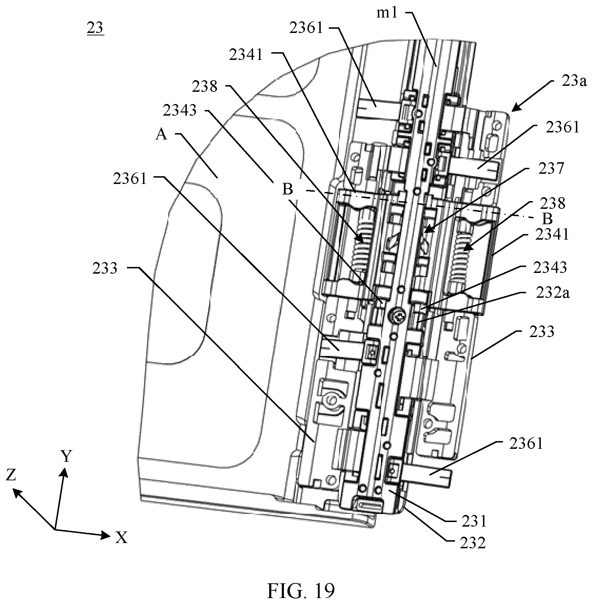

FIG. 18 is an enlarged view of an area I of the rotating shaft mechanism 23 shown in FIG. 17. A secondary middle frame B is hidden in FIG. 18. FIG. 19 is a schematic diagram of a structure of the rotating shaft mechanism 23 shown in FIG. 18 after two door plates 235 are hidden. The rotating shaft mechanism 23 includes a rotating shaft base 231, a shaft cover 232, a first swing arm 233, a second swing arm 2341, an actuating member 2343, a lift slider 232a, a door plate 235, a door plate swing arm 2361, a synchronization mechanism 237, and a damping mechanism 238. The rotating shaft base 231, the shaft cover 232, the first swing arm 233, the second swing arm 2341, the actuating member 2343, and the lift slider 232a form a shaft cover lift system. The door plate 235 and the door plate swing arm 2361 form a door plate moving system.

First, the shaft cover lift system is described.

Specifically, the rotating shaft base 231 provides a location reference. Referring to FIG. 18, the rotating shaft base 231 has a support surface m1. The support surface m1 is configured to support a part of a foldable screen. Specifically, the support surface m1 is configured to support the arc segment 133 of the third display area 13 in the foldable screen 10 in the foldable screen device shown in FIG. 3.

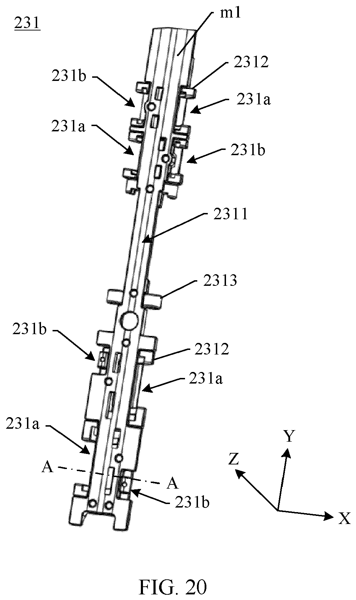

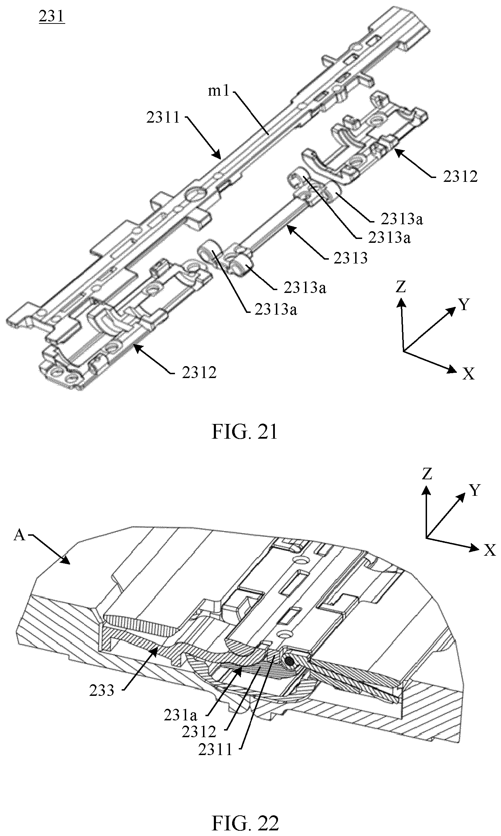

The rotating shaft base 231 may be an integral structural member, or may be formed by assembling a plurality of parts. In some embodiments, FIG. 20 is a three-dimensional view of a rotating shaft base 231 in the rotating shaft mechanism 23 shown in FIG. 18 and FIG. 19. FIG. 21 is an exploded view of the rotating shaft base 231 shown in FIG. 20. In this embodiment, the rotating shaft base 231 includes a base body 2311 and a first connecting piece 2312. The support surface m1 is disposed on the base body 2311. In some embodiments, there are two first connecting pieces 2312, the two first connecting pieces 2312 are located on a back side of the base body 2311, the two first connecting pieces 2312 are disposed at intervals in a length direction of the rotating shaft base 231, and both the two first connecting pieces 2312 are fastened to the base body 2311. Specifically, the two first connecting pieces 2312 may be fastened to the base body 2311 by using a screw lock. In some other embodiments, the two first connecting pieces 2312 may be fastened to the base body 2311 through clamping, welding, or the like. In some other embodiments, there may be one, three, or more first connecting pieces 2312. This is not specifically limited in this embodiment. The two first connecting pieces 2312 and the base body 2311 surround a first connecting part 231a, and the first connecting part 231a is configured to be rotatably connected to the first swing arm 233. In some embodiments, in the two first connecting pieces 2312, each first connecting piece 2312 and the base body 2311 surround two first connecting parts 231a on the left and right, and the two first connecting pieces 2312 and the base body 2311 surround four first connecting parts 231a in total. In the four first connecting parts 231a, two first connecting parts 231a are located on the left, and are configured to be rotatably connected to a first swing arm 233 on the left, and the other two first connecting parts 231a are located on the right, and configured to be rotatably connected to a first swing arm 233 on the right.

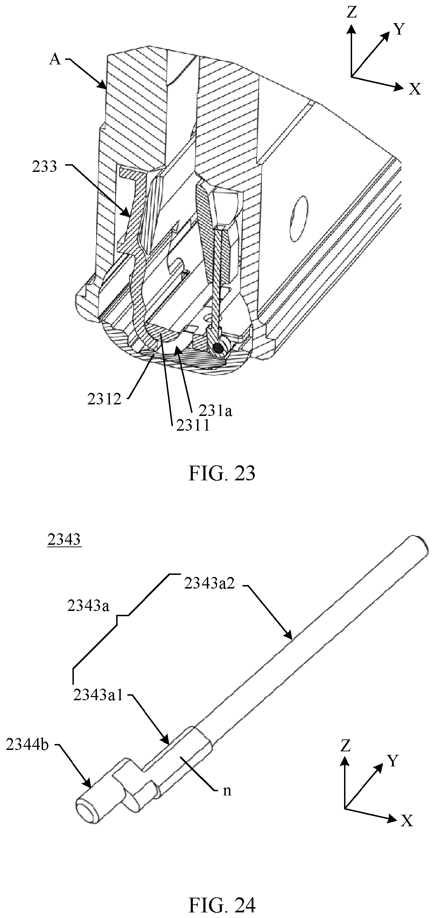

In some embodiments, FIG. 22 is an assembly diagram of a first swing arm 233 and a cross section of the rotating shaft base 231 shown in FIG. 20 at a line A-A. The first connecting part 231a is an arc-shaped sliding groove, and a center line of the arc-shaped sliding groove extends in the length direction (namely, the Y-axis direction) of the rotating shaft base 231. The first swing arm 233 is configured to be fixedly connected to a primary middle frame A, and the first swing arm 233 is rotatably connected to the arc-shaped sliding groove. Specifically, the first swing arm 233 has an arc-shaped sliding sheet, and the arc-shaped sliding sheet is accommodated in the arc-shaped sliding groove through fitting, to implement a rotatable connection. FIG. 22 is a schematic diagram of a structure of a rotating shaft mechanism 23 in an unfolded state. FIG. 23 is a schematic diagram of a structure of the rotating shaft mechanism 23 shown in FIG. 22 in a folded state. In this way, the first connecting piece 2312 and the base body 2311 may limit a rotating shaft part (namely, the arc-shaped sliding sheet) of the first swing arm 233 from two opposite sides of the rotating shaft part, and then the first connecting piece 2312 and the base body 2311 are fastened together. Therefore, the rotating shaft base 231 and the first swing arm 233 are assembled. The assembly operation is simple and highly efficient.

In some embodiments, referring back to FIG. 20, the first connecting parts 231a that are respectively connected to the first swing arms 233 on both sides are disposed at intervals in the length direction (namely, the Y-axis direction) of the rotating shaft base 231. In this way, the connecting parts between the two first swing arms 233 and the rotating shaft base 231 are staggered in the Y-axis direction, so that a width of the rotating shaft base 231 in an X-axis direction can be reduced, thereby reducing a thickness of the foldable screen device in the folded state.

In some embodiments, still referring to FIG. 20 and FIG. 21, the rotating shaft base 231 further includes a second connecting piece 2313. The second connecting piece 2313 is located on the back side of the base body 2311, the second connecting piece 2313 is located between the two first connecting pieces 2312, and the second connecting piece 2313 is fastened to the base body 2311. In some embodiments, the second connecting piece 2313 and the base body 2311 are fastened by using a screw lock. In some other embodiments, the second connecting piece 2313 and the base body 2311 may be fastened through clamping, welding, or the like. In some embodiments, the two first connecting pieces 2312 and the second connecting piece 2313 are successively arranged in the length direction (namely, the Y-axis direction) of the rotating shaft base 231. In this way, a thickness of the rotating shaft base 231 in a Z-axis direction can be reduced. The second connecting piece 2313 is configured to be rotatably connected to the second swing arm 2341 and the actuating member 2343. In this way, after the second swing arm 2341 and the actuating member 2343 are mounted on the second connecting piece 2313, the second connecting piece 2313 is fastened to the base body 2311. The assembly operation is simple and highly efficient.

Specifically, the second connecting piece 2313 may be rotatably connected to the second swing arm 2341 and the actuating member 2343 in the following manner.

Referring to FIG. 21, a shaft sleeve 2313a is disposed on the second connecting piece 2313, and a cylindrical shaft hole is disposed in the shaft sleeve 2313a. In some embodiments, there are four shaft sleeves 2313a. Two shaft sleeves 2313a on the left are configured to be rotatably connected to a second swing arm 2341 on the left and an actuating member 2343 fastened relative to the second swing arm 2341, and two shaft sleeves 2313a on the right are configured to be rotatably connected to a second swing arm 2341 on the right and an actuating member 2343 fastened relative to the second swing arm 2341. Because the rotating shaft mechanism 23 is a vertically symmetric structure, only a manner in which the two shaft sleeves 2313a on the left are rotatably connected to the second swing arm 2341 and the actuating member 2343 is used as an example below for description. A manner in which the two shaft sleeves 2313a on the right are rotatably connected to the second swing arm 2341 and the actuating member 2343 is the same as the foregoing manner in which the two shaft sleeves 2313a on the left are rotatably connected to the second swing arm 2341 and the actuating member 2343. Details are not described herein again.

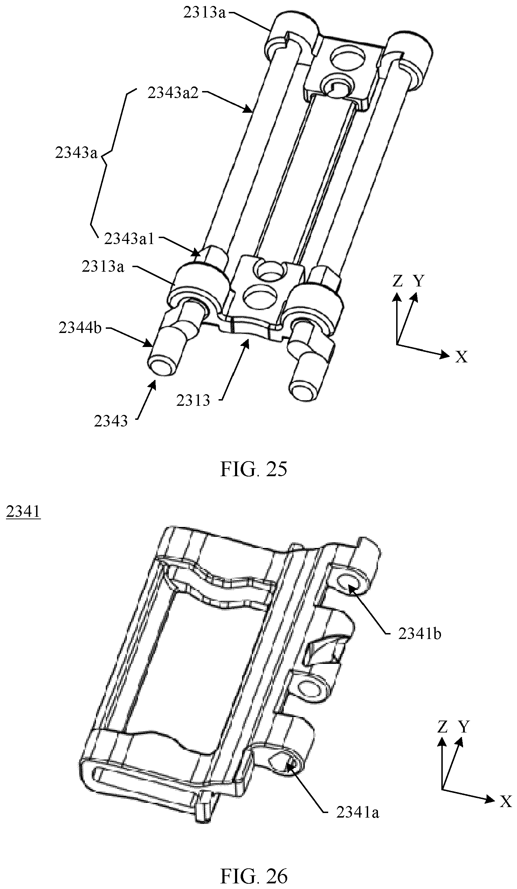

Specifically, FIG. 24 is a schematic diagram of a structure of an actuating member 2343 in the rotating shaft mechanism 23 shown in FIG. 19. The actuating member 2343 includes a rotating shaft part 2343a. The rotating shaft part 2343a includes a first segment 2343a1 and a second segment 2343a2, and a flat location n is disposed on a side surface of the first segment 2343a1. In some embodiments, the flat location n is disposed on two opposite side surfaces of the first segment 2343a1. In some other embodiments, the flat location n may be disposed on one, three, or four sides of a circumference of the first segment 2343a1. This is not specifically limited herein. A cross section of the second segment 2343a2 is circular. FIG. 25 is an assembly diagram of the actuating member 2343 shown in FIG. 24 and a second connecting piece 2313 in the rotating shaft base 231 shown in FIG. 21. The rotating shaft part 2343a of the actuating member 2343 penetrates into two shaft sleeves 2313a on the left of the second connecting piece 2313, and can rotate in the two shaft sleeves 2313a.

Still referring to FIG. 24, the actuating member 2343 also includes an eccentric protrusion part. The eccentric protrusion part is the second sliding member 2344b in the rotating shaft mechanism 23 shown in FIG. 14. The eccentric protrusion part may also be replaced with an eccentric wheel, an eccentric roller, an eccentric rolling drum, and the like. This is not specifically limited herein.

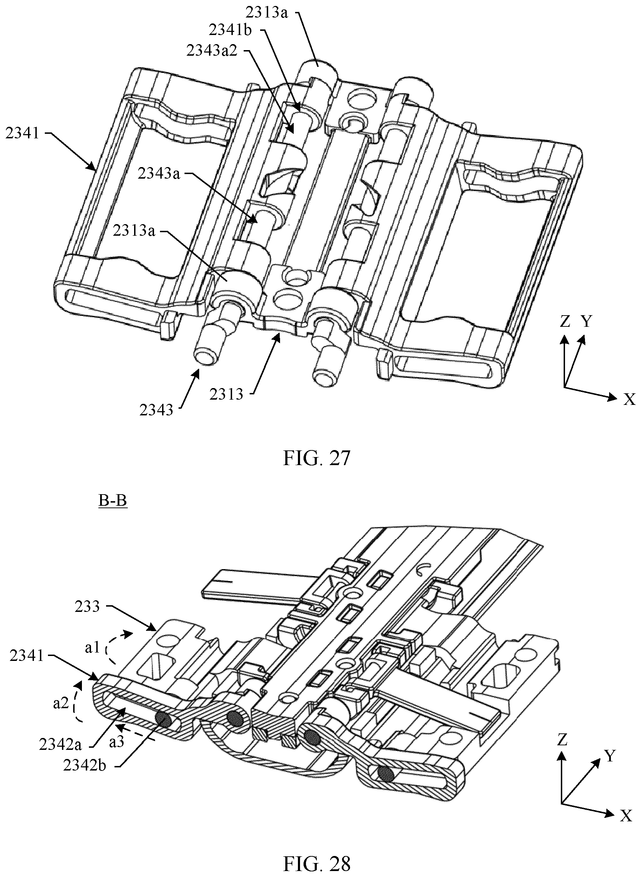

FIG. 26 is a schematic diagram of a structure of a second swing arm 2341 in the rotating shaft mechanism 23 shown in FIG. 19. A flat hole 2341a and a round hole 2341b are disposed on the second swing arm 2341. A shape and a size of the flat hole 2341a adapt to a shape and a size of a cross section of the first segment 2343a1 of the actuating member 2343 shown in FIG. 22, and a shape and a size of the round hole 2341b adapt to a shape and a size of a cross section of the second segment 2343a2 of the actuating member 2343 shown in FIG. 22. FIG. 27 is an assembly diagram of the assembly structure shown in FIG. 25 and the second swing arm 2341 shown in FIG. 26. The second swing arm 2341 is connected to a part that is of the rotating shaft part 2343a and that is located between the two shaft sleeves 2313a, to limit the second swing arm 2341 by using the two shaft sleeves 2313a. On this basis, the second swing arm 2341 is sleeved on the rotating shaft part 2343a through fitting by using the flat hole 2341a (not shown in the figure), to prevent, by using the flat location, the second swing arm 2341 from rotating relative to the actuating member 2343. In addition, the second swing arm 2341 is further sleeved on the second segment 2343a2 by using the round hole 2341b.

In this way, the second connecting piece 2313 is rotatably connected to the second swing arm 2341 and the actuating member 2343, and locations of the second swing arm 2341 and the actuating member 2343 are fixed. Therefore, when rotating, the second swing arm 2341 can drive the actuating member 2343 to rotate with the second swing arm 2341. The structure is convenient to assemble, and has good stability.

In some other embodiments, the second swing arm 2341 may be prevented, through pin fastening, interference fit, or the like, from rotating relative to the actuating member 2343. This is not specifically limited herein.

It should be noted that, in the foregoing embodiments, the second swing arm 2341 and the actuating member 2343 are two mutually independent structural members. In some other embodiments, the second swing arm 2341 and the actuating member 2343 may be an integral structural member, that is, the second swing arm 2341 and the actuating member 2343 are integrally formed. In this way, the rotating shaft mechanism 23 includes a small quantity of parts, complexity of a composition structure is low, and the structure is simpler.

FIG. 28 is a schematic diagram of a cross-sectional structure of the rotating shaft mechanism 23 shown in FIG. 19 at a line B-B. A first sliding member 2342b is disposed on the first swing arm 233, a first sliding groove 2342a is disposed on the second swing arm 2341, and the first sliding member 2342b is slidably connected in the first sliding groove 2342a. When rotating from an unfolded location to a folded location in a direction a1, the first swing arm 233 may drive the first sliding groove 2342a by using the first sliding member 2342b, so that the second swing arm 2341 rotates in a direction a2, and the first sliding member 2342b slides in the first sliding groove 2342a in a direction a3. On this basis, when rotating from the folded location to the unfolded location in a direction opposite to the direction a1, the first swing arm 233 may drive the first sliding groove 2342a by using the first sliding member 2342b, so that the second swing arm 2341 rotates in a direction opposite to the direction a2, and the first sliding member 2342b slides in the first sliding groove 2342a in a direction opposite to the direction a3.

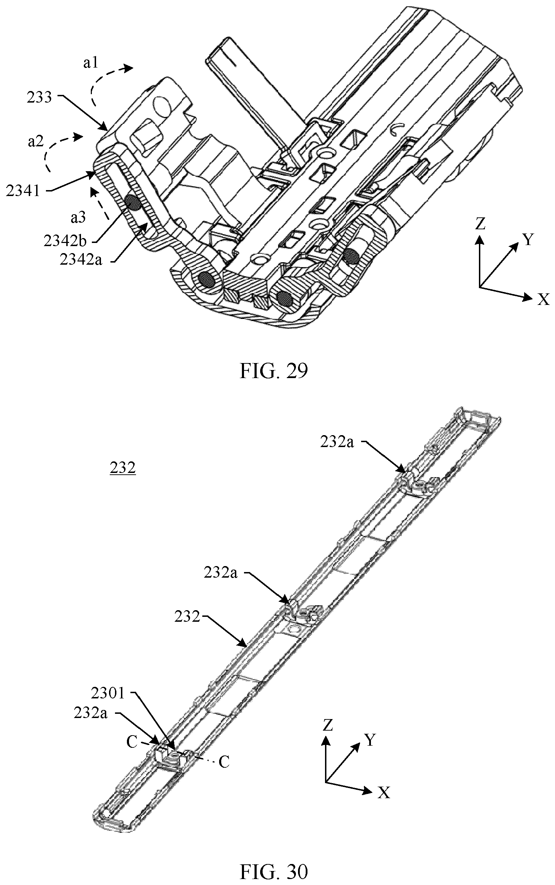

FIG. 29 is a schematic diagram of a structure of the rotating shaft mechanism 23 shown in FIG. 28 in a half folded state. The half folded state is a state in which the rotating shaft mechanism 23 is located when the first swing arm 233 rotates from the unfolded location to the folded location by a specific angle and the angle is less than a rotation angle existing when the first swing arm 233 rotates to the folded location.

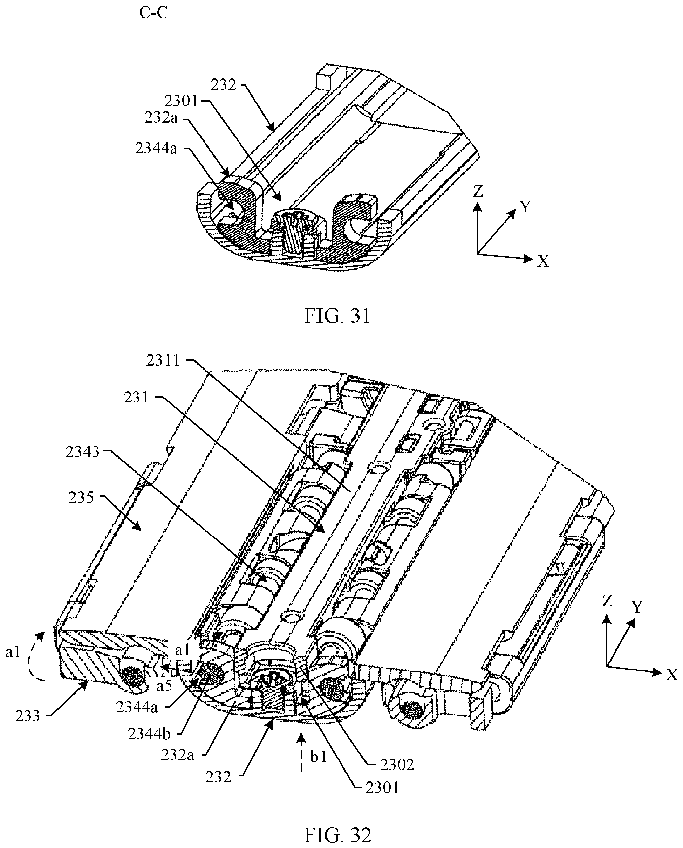

FIG. 30 is a schematic diagram of a structure of a shaft cover 232 in the rotating shaft mechanism 23 shown in FIG. 19. A lift slider 232a is disposed on an inner surface of the shaft cover 232. The inner surface of the shaft cover 232 is a surface that is of the shaft cover 232 and that faces the foldable screen. There are three lift sliders 232a, and the three lift sliders 232a are respectively included in the first rotating shaft part 23a, the second rotating shaft part 23b, and the third rotating shaft part 23c in FIG. 17. The lift slider 232a and the shaft cover 232 may be two independent structural members, or may be an integral structural member, that is, the lift slider 232a and the shaft cover 232 are integrally formed. In the embodiment shown in FIG. 30, the shaft cover 232 and the lift slider 232a are two independent structural members, and the shaft cover 232 and the lift slider 232a are fastened together by using a screw. In some other embodiments, the shaft cover 232 and the lift slider 232a may be fastened together through clamping, welding, or the like. FIG. 31 is a schematic diagram of a cross-sectional structure of the shaft cover 232 shown in FIG. 30 at a line C-C. A second sliding groove 2344a is disposed on the lift slider 232a, and the second sliding groove 2344a is configured to be slidably connected to the second sliding member 2344b on the actuating member 2343 shown in FIG. 24. FIG. 32 is a schematic diagram of an assembly structure of the shaft cover 232 and the lift slider 232a shown in FIG. 31 and a second sliding member 2344b on an actuating member 2343. The eccentric protrusion part (namely, the first sliding member 2344b) of the actuating member 2343 penetrates into the second sliding groove 2344a on the lift slider 232a, and can slide along the second sliding groove 2344a. In this way, when the first swing arm 233 rotates from the unfolded location to the folded location in the direction a1, the actuating member 2343 rotates with the second swing arm 2341 in a direction a4, and may drive the second sliding groove 2344a by using the eccentric protrusion part, to drive the lift slider 232a to move upward in a direction b1. In addition, the eccentric protrusion part slides in the second sliding groove 2344a in a direction a5. On this basis, when the first swing arm 233 rotates from the folded location to the unfolded location in a direction opposite to the direction a1, the actuating member 2343 rotates with the second swing arm 2341 in a direction opposite to the direction a4, and may drive the second sliding groove 2344a by using the eccentric protrusion part, to drive the lift slider 232a to move downward in a direction opposite to the direction b1. In addition, the eccentric protrusion part slides in the second sliding groove 2344a in a direction opposite to the direction a5.

Referring back to FIG. 30 and FIG. 31, a limiting sliding groove 2301 is further disposed on the lift slider 232a. Referring to FIG. 32, a limiting sliding member 2302 is disposed on the rotating shaft base 231. Optionally, the limiting sliding member 2302 may be disposed on the base body 2311 of the rotating shaft base 231. In some other embodiments, the limiting sliding member 2302 may be disposed on the first connecting piece 2312 or the second connecting piece 2313 of the rotating shaft base 231. Referring to FIG. 32, the limiting sliding member 2302 is disposed in the limiting sliding groove 2301 through fitting, and can slide upward and downward along the limiting sliding groove 2301. The limiting sliding groove 2301 and the limiting sliding member 2302 form a sliding constraint, to allow the shaft cover 232 to move upward and downward in a thickness direction (namely, the Z-axis direction) of the rotating shaft base 231, and prevent the shaft cover 232 from moving along a plane (namely, an XY plane) perpendicular to the thickness direction of the rotating shaft base 231, so as to avoid misalignment or jamming.

In some embodiments, mainly referring to FIG. 32, a connecting part between the shaft cover 232 and the lift slider 232a is located in the limiting sliding groove 2301. An avoidance hole is disposed at a location that is on the limiting sliding member 2302 and that corresponds to the connecting part, and the connecting part is accommodated in the avoidance hole. Therefore, the thickness of the rotating shaft mechanism 23 can be reduced.

It should be noted that disposition locations of the limiting sliding groove 2301 and the limiting sliding member 2302 may be interchanged, and the limiting sliding groove 2301 and the limiting sliding member 2302 may be replaced with another sliding constraint assembly (for example, a guide rail and a slider). This is not specifically limited in this application.

Based on the foregoing descriptions, the second swing arm 2341, the first sliding groove 2342a, the first sliding member 2342b, the actuating member 2343 (on which the second sliding member 2344b is disposed), and the lift slider 232a (on which the second sliding groove 2344a is disposed) form a first drive mechanism. Therefore, when rotating from the unfolded location to the folded location, the first swing arm 233 may drive, by using the first drive mechanism, the shaft cover 232 to move upward, to compensate for a step difference between the shaft cover and the housing, and avoid exposing an internal structure. In addition, when rotating from the folded location to the unfolded location, the first swing arm 233 may drive, by using the first drive mechanism, the shaft cover 232 to move downward, to implement reset. The structure of the first drive mechanism is simple and easy to implement. Based on the foregoing descriptions, the first drive mechanism may have another structure form. For specific descriptions, refer to the foregoing descriptions. Details are not described herein again.

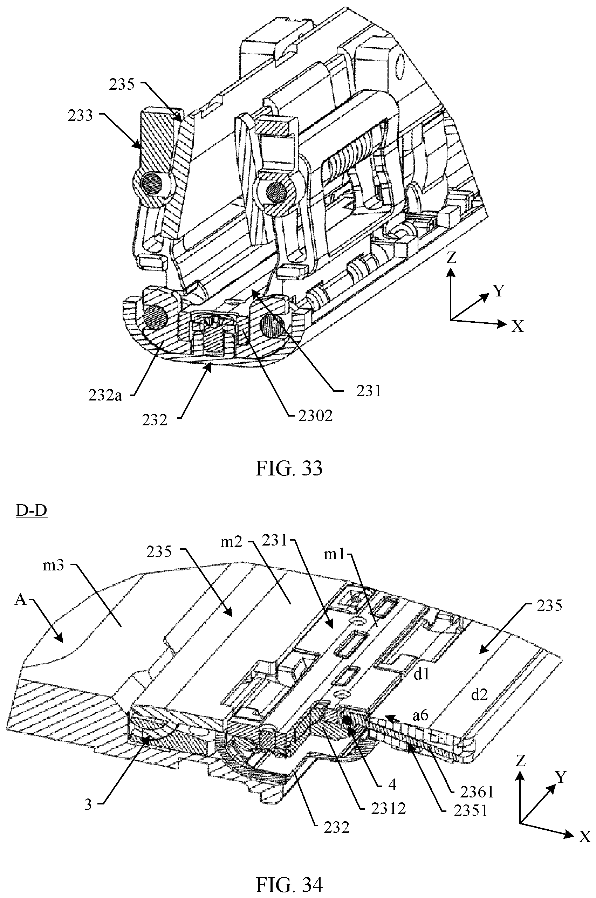

In FIG. 32, the rotating shaft mechanism 23 is in the unfolded state. FIG. 33 is a schematic diagram of a structure of the rotating shaft mechanism 23 shown in FIG. 32 in a folded state. It can be learned from comparison between FIG. 32 and FIG. 33 that, when the rotating shaft mechanism 23 rotates from the unfolded state shown in FIG. 32 to the folded state shown in FIG. 33, the shaft cover 232 moves upward by a specific height relative to the rotating shaft base 231; and when the rotating shaft mechanism 23 rotates from the folded state shown in FIG. 33 to the unfolded state shown in FIG. 32, the shaft cover 232 moves downward by a specific height relative to the rotating shaft base 231.

Next, the following describes the door plate moving system in the rotating shaft mechanism 23 shown in FIG. 18 and FIG. 19.

Specifically, FIG. 34 is a schematic diagram of a cross-sectional structure of the rotating shaft mechanism 23 shown in FIG. 18 at a line D-D. In this embodiment, the rotating shaft mechanism 23 is in the unfolded state, and a surface m3 that is of the primary middle frame A and that is used to dispose the foldable screen, a surface m2 that is of the door plate 235 and that is used to dispose the foldable screen, and a surface m1 that is of the rotating shaft base 231 and that is used to dispose the foldable screen are approximately coplanar. Door plates 235 on both sides are connected in a same manner. The door plate 235 is rotatably connected to the first swing arm 233 by using a rotating pair 3, and a third sliding groove 2351 is disposed in the door plate 235. The door plate swing arm 2361 is rotatably connected to the rotating shaft base 231 by using a rotating pair 4. In some embodiments, the door plate swing arm 2361 is rotatably connected to the first connecting piece 2312 of the rotating shaft base 231. The door plate swing arm 2361 slidably penetrates into the third sliding groove 2351. On this basis, when rotating from the unfolded location to the folded location, the first swing arm 233 may drive the door plate swing arm 2361 to slide relative to the door plate 235 in a direction a6, and drive an end d1 that is of the door plate 235 and that is close to the rotating shaft base 231 to tilt toward a side away from the foldable screen relative to an end d2 away from the rotating shaft base 231.

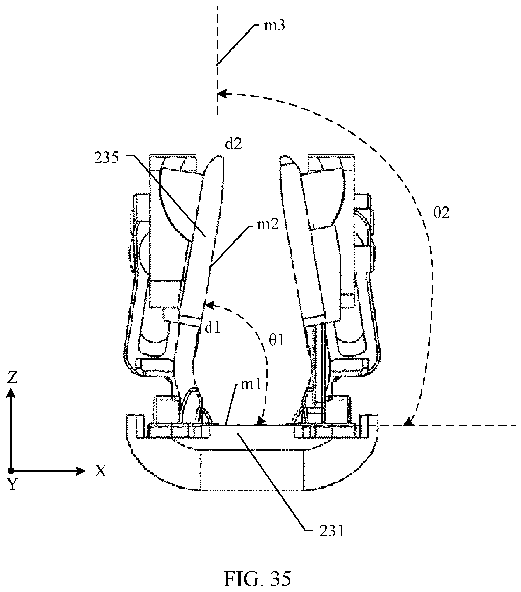

In this way, when the first swing arm 233 rotates to the folded location, FIG. 35 is a schematic diagram of a structure of the rotating shaft mechanism 23 shown in FIG. 18 in a folded state, an included angle between m2 and m1 is a first angle θ1, an included angle between m3 and m1 is a second angle θ2, and the first angle θ1 is less than the second angle θ2. It can be inferred that, when the first swing arm 233 rotates from the unfolded location to the folded location, a rotation angle of the door plate 235 relative to the rotating shaft base 231 is greater than a rotation angle of the middle frame relative to the rotating shaft base 231. Because the middle frame is fastened to the first swing arm 233, the rotation angle of the middle frame relative to the rotating shaft base 231 is equal to a rotation angle of the first swing arm 233 relative to the rotating shaft base 231. In other words, the rotation angle of the door plate 235 relative to the rotating shaft base 231 is greater than the rotation angle of the first swing arm 233 relative to the rotating shaft base 231. When the rotation angle of the first swing arm 233 is 90°, the rotation angle of the door plate 235 may be 100°, 105°, 102°, 110°, or the like. This is not specifically limited herein. In this way, a third display area of the foldable screen may be folded into a water drop shape, to reduce an inward folding angle, reduce a probability that a crease occurs on the foldable screen, ensure a display effect of the foldable screen, and prolong a life span of the foldable screen.

In the foregoing embodiment, the door plate swing arm 2361 forms a second drive mechanism. When rotating from the unfolded location to the folded location, the first swing arm 233 may drive, by using the second drive mechanism, the end b1 that is of the door plate 235 and that is close to the rotating shaft base 231 to tilt toward the side away from the foldable screen relative to the end b2 away from the rotating shaft base 231, to form a foldable screen structure in a water drop shape; and when rotating from the folded location to the unfolded location, the first swing arm 233 may drive, by using the second drive mechanism, the end b1 that is of the door plate 235 and that is close to the rotating shaft base 231 to tilt toward the side away from the foldable screen relative to the end b2 away from the rotating shaft base 231, so that m1, m2, and m3 are approximately coplanar, to keep the foldable screen flat. It can be learned that the second drive mechanism may have another structure form. For specific descriptions, refer to the foregoing descriptions. Details are not described herein again.

Based on the shaft cover lift system and the door plate moving system that are described above, specifically, because the rotating shaft mechanism 23 includes two parts that are vertically symmetric, in the rotating shaft mechanism 23 shown in FIG. 17 and FIG. 18, each part includes six parts (M) in total: the rotating shaft base 231, the shaft cover 232, the first swing arm 233, the second swing arm 2341 (with the actuating member 2343), the door plate 235, and the door plate swing arm 2361. In a process in which the rotating shaft mechanism 23 moves between the unfolded state and the folded state, the six parts have a unique movement manner, and have good stability.

Then, the synchronization mechanism 237 in the rotating shaft mechanism 23 shown in FIG. 17 and FIG. 18 is described.

A function of the synchronization mechanism 237 is as follows: When rotating from the unfolded location to the folded location, either of the two first swing arms 233 can drive, by using the synchronization mechanism 237, the other first swing arm 233 to synchronously rotate from the unfolded location to the folded location. Similarly, when rotating from the folded location to the unfolded location, either of the two first swing arms 233 can also drive, by using the synchronization mechanism 237, the other first swing arm 233 to synchronously rotate from the folded location to the unfolded location.

In some embodiments, when the two first swing arms 233 synchronously rotate, rotation angles of the two first swing arms 233 also remain consistent. It can be understood that, due to a manufacturing or assembly tolerance, there may be a specific angle deviation between the two first swing arms 233 in a rotation process. Therefore, generally, when the two first swing arms 233 rotate from the unfolded location to the folded location, if a deviation range of the rotation angle is between 0 and 20°, it can be considered that the rotation angles of the two first swing arms 233 remain consistent. In this way, the two first swing arms 233 may synchronously rotate by a same angle by using the synchronization mechanism, to reduce difficulty in folding and unfolding the foldable screen device.

Movement of the rotating shaft mechanism 23 shown in FIG. 18 and FIG. 19 is unique. When the synchronization mechanism 237 is disposed between any two moving structural members that are symmetric, shaft cover lift systems and door plate moving systems on both sides may be driven to synchronously move. Therefore, in addition to being directly connected between the two first swing arms 233, the synchronization mechanism 237 may be further connected between two second swing arms 2341, or connected between two door plate swing arms 2361. When the synchronization mechanism 237 is connected between the two second swing arms 2341, the two first swing arms 233 may be indirectly driven, by using the shaft cover lift system, to synchronously rotate. When the synchronization mechanism 237 is connected between the two door plate swing arms 2361, the two first swing arms 233 may also be indirectly driven, by using the door plate moving system, to synchronously rotate.

In some embodiments, the synchronization mechanism 237 is connected between the two second swing arms 2341, and there is sufficient space between the two second swing arms 2341 to facilitate mounting of the synchronization mechanism 237.

The synchronization mechanism 237 has a plurality of structure forms. For example, the synchronization mechanism 237 includes an even quantity of successively meshed drive gears (not shown in the figure). Specifically, the quantity of drive gears may be two, four, six, or the like. The even quantity of drive gears includes a first drive gear and a second drive gear that are respectively located at a head location and a tail location, the first drive gear and the second drive gear are respectively configured to be fastened relative to the two second swing arms 2341, and a center axis of the first drive gear and a center axis of the second drive gear are respectively collinear with rotation axes of the two second swing arms 2341. Therefore, the even quantity of drive gears are meshed for driving, so that the two second swing arms 2341 can be driven to synchronously swing. The structure is simple and easy to implement. In addition, if a larger quantity of drive gears are designed, a smaller height of the drive gear in the Z-axis direction may be designed, to further help implement thinning of the rotating shaft mechanism 23. However, a larger quantity of drive gears indicates higher structure complexity, a smaller volume of the drive gear, and larger processing difficulty. Therefore, based on different design requirements, thinning, structure complexity, and processing difficulty of the rotating shaft mechanism 23 may be comprehensively considered to select different quantities of drive gears.

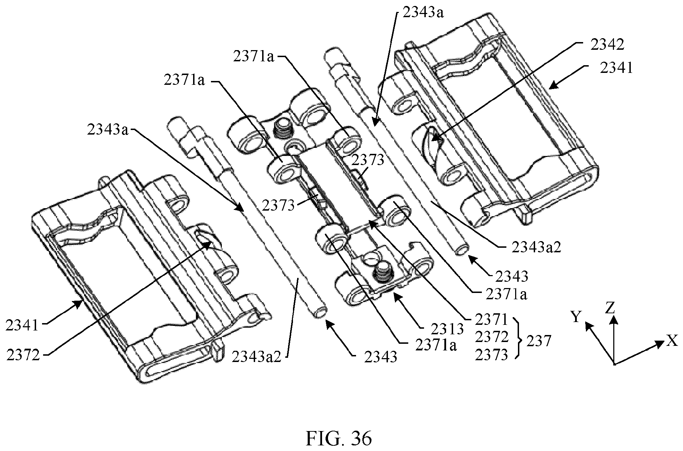

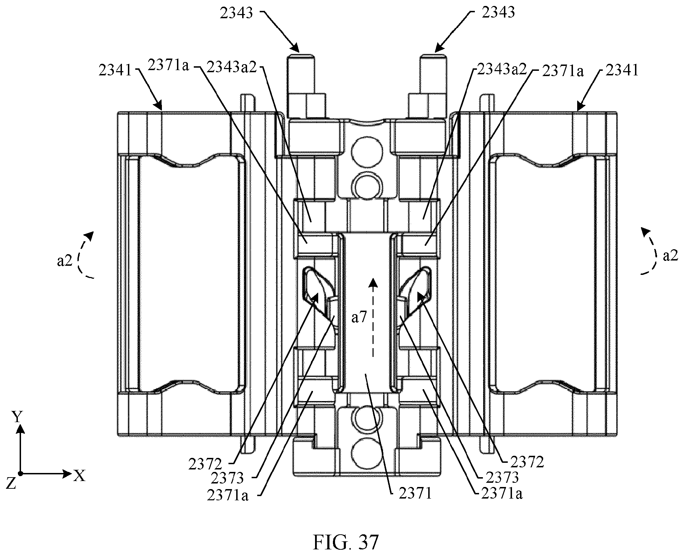

For another example, FIG. 36 is an exploded view of a synchronization mechanism 237, a second connecting piece 2313, a second swing arm 2341, and an actuating member 2343 in the rotating shaft mechanism 23 shown in FIG. 19. FIG. 37 is an assembly diagram of a synchronization mechanism 237, a second connecting piece 2313, a second swing arm 2341, and an actuating member 2343 in the rotating shaft mechanism 23 shown in FIG. 36. In this embodiment, the synchronization mechanism 237 includes a drive slider 2371. The drive slider 2371 is located between the second swing arms 2341 of the two first drive mechanisms. In addition, optionally, the drive slider 2371 is located between the base body 2311 and the second connecting piece 2313 in the rotating shaft base 231 shown in FIG. 21.

The drive slider 2371 is slidably connected to the rotating shaft base 231 in the length direction (namely, the Y-axis direction) of the rotating shaft base. Based on the foregoing descriptions, the rotating shaft part 2343a of the actuating member 2343 penetrates into the shaft sleeve of the second connecting piece 2313 in the rotating shaft base, and can rotate in the shaft sleeve. On this basis, optionally, a shaft sleeve 2371a is disposed on the drive slider 2371. In some embodiments, there are four shaft sleeves 2371a. In the four shaft sleeves 2371a, two shaft sleeves 2371a on the left are sleeved on a second segment 2343a2 of a rotating shaft part 2343a in an actuating member 2341 on the left, and can slide along the second segment 2343a2; and two shaft sleeves 2371a on the right are sleeved on a second segment 2343a2 of a rotating shaft part 2343a in an actuating member 2341 on the right, and can slide along the second segment 2343a2. In this way, the second segment 2343a2 of the rotating shaft part 2343a in the actuating member 2343 is used as a sliding guide rail, and the drive slider 2371 is slidably connected to the sliding guide rail by using the shaft sleeve 2371a. Therefore, the drive slider 2371 and the rotating shaft base are slidably connected to each other. The structure is simple, and no sliding guide rail needs to be specially disposed. Therefore, structure complexity of the rotating shaft mechanism 23 can be reduced.

It can be learned that another quantity of shaft sleeves 2371a may be disposed on the drive slider 2371. This is not specifically limited herein. In addition, the drive slider 2371 and the rotating shaft base may be slidably connected to each other in another manner. This is not specifically limited in this application.

On the foregoing basis, referring to FIG. 37, the drive slider 2371 is drivably connected to the two second swing arms 2341. In this way, when rotating from the unfolded location to the folded location in the direction a2, either of the two second swing arms 2341 can drive the drive slider 2371 to slide in a direction a7 (consistent with the Y-axis direction), and drive the other second swing arm 2341 to synchronously rotate from the unfolded location to the folded location in the direction a2. On the contrary, when rotating from the folded location to the unfolded location in the direction opposite to the direction a2, either of the two second swing arms 2341 can drive the drive slider 2371 to slide in a direction (namely, a direction opposite to the Y-axis direction, namely, a -Y-axis direction) opposite to the direction a7, and drive the other second swing arm 2341 to synchronously rotate from the folded location to the unfolded location in the direction opposite to the direction a2. It should be noted that the unfolded location of the second swing arm 2341 is a location at which the second swing arm 2341 is located when the rotating shaft mechanism 23 is in the unfolded state, and the folded location of the second swing arm 2341 is a location at which the second swing arm 2341 is located when the rotating shaft mechanism 23 is in the folded state.

On the foregoing basis, the two first swing arms in the rotating shaft mechanism 23 may be indirectly driven, by using the shaft cover lift system, to synchronously rotate.

The synchronization mechanism 237 occupies a small height in the Z-axis direction, so that a thickness of the rotating shaft mechanism 23 can be reduced, to facilitate thinning of the foldable screen device.

In the foregoing embodiment, the drivable connection manner between the drive slider 2371 and the second swing arm 2341 includes but is not limited to a drivable connection obtained by using a structure including a lead screw and a nut, a drivable connection obtained by using a structure including a spiral sliding groove and a slider, or a drivable connection obtained by using a structure including a worm gear and a worm. This is not specifically limited herein.

In some embodiments, referring to FIG. 36 and FIG. 37, a spiral sliding groove 2372 is disposed on the second swing arm 2341, and a slider 2373 is disposed on the drive slider 2371. In some other embodiments, disposition locations of the spiral sliding groove 2372 and the slider 2373 may be interchanged, that is, the spiral sliding groove 2372 is disposed on the drive slider 2371, and the slider 2373 is disposed on the second swing arm 2341. A center line of a spiral extension path of the spiral sliding groove 2372 is parallel to a slidable direction (namely, the Y-axis direction) of the drive slider 2371. The slider 2373 is slidably disposed in the spiral sliding groove 2372. In other words, the slider 2373 is disposed in the spiral sliding groove 2372, and the slider 2373 can slide in an extension direction of the spiral sliding groove 2372.

In this way, when rotating from the unfolded location to the folded location in the direction a2, either of the two second swing arms 2341 can drive, by using the spiral sliding groove 2372 on the second swing arm 2341, the drive slider 2371 to slide in the direction a7, and drive, by using the slider 2373 on the drive slider 2371, the other second swing arm 2341 to rotate synchronously from the unfolded location to the folded location in the direction a2. On the contrary, when rotating from the folded location to the unfolded location in the direction opposite to the direction a2, either of the two second swing arms 2341 can drive, by using the spiral sliding groove 2372 on the second swing arm 2341, the drive slider 2371 to slide in the direction opposite to the direction a7, and drive, by using the slider 2373 on the drive slider 2371, the other second swing arm 2341 to rotate synchronously from the folded location to the unfolded location in the direction opposite to the direction a2. The drivable connection manner between the drive slider 2371 and the second swing arm 2341 is a drivable connection obtained by using a structure including a spiral sliding groove and a slider. The structure is simple, and occupies small space, to facilitate a compact structure design of the rotating shaft mechanism.

Finally, the damping mechanism 238 in the rotating shaft mechanism 23 shown in FIG. 17 and FIG. 18 is described.

Specifically, a function of the damping mechanism 238 is as follows: When the first swing arm 233 rotates relative to the rotating shaft base 231, the damping mechanism 238 applies damping force to the first swing arm 233 to prevent the first swing arm 233 from rotating. In this way, the foldable screen device may be kept at one unfolding angle location, a plurality of unfolding angle locations, or any unfolding angle location, to ensure structure stability of the foldable screen device at these unfolding angle locations.

The damping mechanism 238 has a plurality of structure forms. For example, the damping force is provided by using a lateral friction sheet. For another example, the damping force is provided by using tension between an odd-form rotating shaft and a shaft sleeve. For another example, the damping force is provided by using an elastic material such as rubber or silicone mounted between a rotating shaft and a shaft sleeve. This is not specifically limited in this application.

In addition, because movement of the rotating shaft mechanism 23 shown in FIG. 18 and FIG. 19 is unique, when the damping mechanism 238 is disposed at any moving pair location, the entire mechanism can be prevented from moving. Therefore, in addition to being directly disposed on a rotating pair part between the first swing arm 233 and the rotating shaft base 231, the damping mechanism 238 may be further disposed on a rotating pair part between the second swing arm 2341 and the rotating shaft base 231, or disposed on a sliding pair part between the first swing arm 233 and the second swing arm 2341, or disposed on a sliding pair part between the actuating member 2343 and the shaft cover 232, or disposed on a connecting part between moving pairs in the door plate moving system. This is not specifically limited herein. An example in which the damping mechanism 238 is disposed on the sliding pair part between the first swing arm 233 and the second swing arm 2341 is used below for description. This should not be construed as a special limitation on this application.

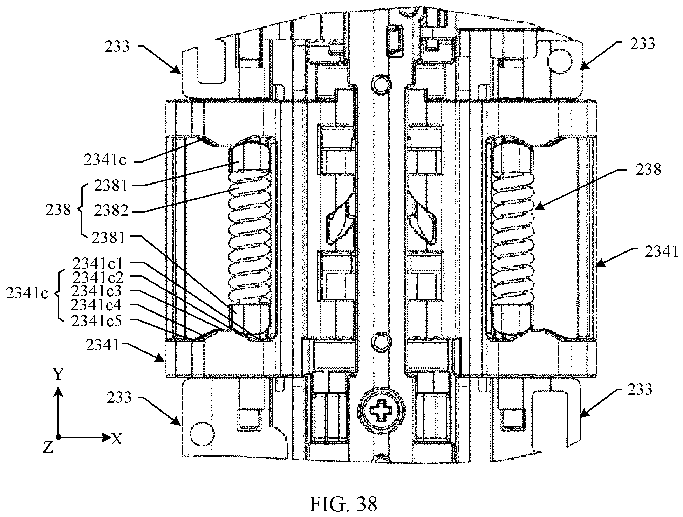

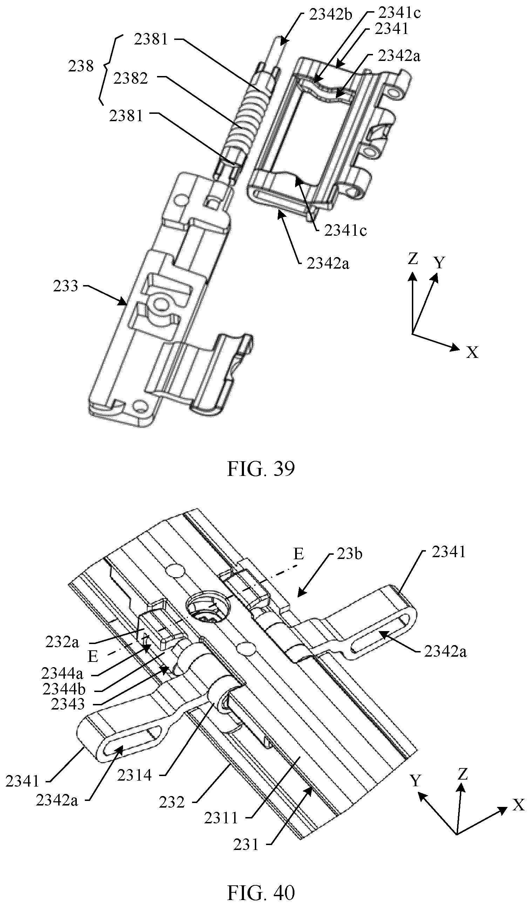

Specifically, FIG. 38 is an assembly diagram of a damping mechanism 238, a first swing arm 233, and a second swing arm 2341 in the rotating shaft mechanism 23 shown in FIG. 19. FIG. 39 is an exploded view of a damping mechanism 238, a first swing arm 233, and a second swing arm 2341 in the rotating shaft mechanism 23 shown in FIG. 38. In this embodiment, there are two damping mechanisms 238, and the two damping mechanisms 238 are separately connected between the first swing arms 233 and the second swing arms 2341 on both sides. The damping mechanism 238 connected between the first swing arm 233 and the second swing arm 2341 on the left is used as an example for description in the following embodiments. A structure form of the damping mechanism 238 on the right is the same as a structure form of the damping mechanism 238 on the left, and details are not described again below.

Referring to FIG. 38 and FIG. 39, an end surface of the first sliding groove 2342a on the second swing arm 2341 in the length direction (namely, the Y-axis direction) of the rotating shaft base 231 is a friction surface 2341c. It should be noted that the first sliding groove 2342a described in this embodiment is not non-solid sliding groove space on the second swing arm 2341, but is a whole including non-solid sliding groove space on the second swing arm 2341 and a solid side wall surrounding the sliding groove space. The friction surface 2341c is disposed on the solid side wall surrounding the sliding groove space.

On the foregoing basis, the damping mechanism 238 is connected to the first sliding member 2342b. When sliding along the first sliding groove 2342a, the first sliding member 2342b may drive the damping mechanism 238 to move along the friction surface 2341c.

The damping mechanism 238 includes a friction member 2381 and an elastic member 2382. In the embodiments shown in FIG. 38 and FIG. 39, both the friction member 2381 and the elastic member 2382 of the damping mechanism 238 are sleeved on the first sliding member 2342b. In some other embodiments, the elastic member 2382 of the damping mechanism 238 may be fastened to the first sliding member 2342b. This is not specifically limited in this application. The friction member 2381 is located on a side faced by the friction surface 2341c. The elastic member 2382 is configured to apply, to the friction member 2381, elastic force pointing to the friction surface 2341c, so that the friction member 2381 abuts the friction surface 2341c. "Abut" indicates that the friction member 2381 and the friction surface 2341c are in contact with each other and have specific extrusion force on each other. In this way, when the first sliding member 2342b slides along the first sliding groove 2342a, friction force is generated between the friction member 2381 and the friction surface 2341c. The friction force forms damping force, to prevent the first sliding member 2342b from sliding relative to the first sliding groove 2342a, thereby preventing the first swing arm 233 from rotating relative to the rotating shaft base. The structure is simple and easy to implement.

In the foregoing embodiment, the elastic member 2382 may be an elastic material such as a coil spring, rubber, or silicone. In the embodiments shown in FIG. 38 and FIG. 38, the elastic member 2382 is a coil spring. The coil spring has high elasticity, has good stability, and has a long life span. Therefore, structure stability of the rotating shaft mechanism 23 can be ensured, and a life span can be prolonged.

In some embodiments, referring to FIG. 38, the friction surface 2341c is a cam surface, and the cam surface includes a first bottom area 2341c1, a rising area 2341c2, a top area 2341c3, a falling area 2341c4, and a second bottom area 2341c5 that are successively disposed in a length direction of the first sliding groove 2342a. When the first swing arm 233 is at the unfolded location, the friction member 2381 is in contact with the first bottom area 2341c1. When the first swing arm 233 rotates from the unfolded location to the folded location, the friction member 2381 abuts the friction surface 2341c, and slides successively along the rising area 2341c2, the top area 2341c3, and the falling area 2341c4. In this case, damping force is generated between the friction member 2381 and the friction surface 2341c to prevent the friction member 2381 and the friction surface 2341c from sliding relative to each other. When the first swing arm 233 is at the folded location, the friction member 2381 is in contact with the second bottom area 2341c5. In this way, when the rotating shaft mechanism 23 rotates between the unfolded state and the folded state, the damping force generated between the friction member 2381 and the friction surface 2341c needs to be overcome. When no external force is applied, the rotating shaft mechanism 23 may be kept in the unfolded state and the folded state. This is consistent with a use habit of the user.

In some embodiments, still referring to FIG. 38 and FIG. 39, there are two first sliding grooves 2342a, the two first sliding grooves 2342a are disposed at intervals in the Y-axis direction and are fastened relative to each other, and friction surfaces 2341c of the two first sliding grooves 2342a are opposite to each other. On this basis, the damping mechanism 238 is disposed between the two first sliding grooves 2342a, there are two friction members 2381, the elastic member 2382 is located between the two friction members 2381, and the elastic member 2382 simultaneously applies, to the two friction members 2381, elastic force pointing to corresponding friction surfaces 2341c, so that the two friction members 2381 respectively abut the corresponding friction surfaces 2341c. In this way, when the rotating shaft mechanism 23 rotates between the unfolded state and the folded state, the damping force generated by the damping mechanism 238 is large, and large driving force needs to be applied, so that the rotating shaft mechanism 23 can be stably kept in the unfolded state or the folded state, thereby improving use stability of the rotating shaft mechanism 23.

The first rotating shaft part 23a of the rotating shaft mechanism 23 shown in FIG. 17 is described in the foregoing embodiments. A structure form of the third rotating shaft part 23c is the same as a structure form of the first rotating shaft part 23a. Details are not described herein again. A structure form of the second rotating shaft part 23b is different from those of the first rotating shaft part 23a and the third rotating shaft part 23c, and the first rotating shaft part 23a, the second rotating shaft part 23b, and the third rotating shaft part 23c share the same rotating shaft base 231.

The following describes a specific structure of the second rotating shaft part 23b.

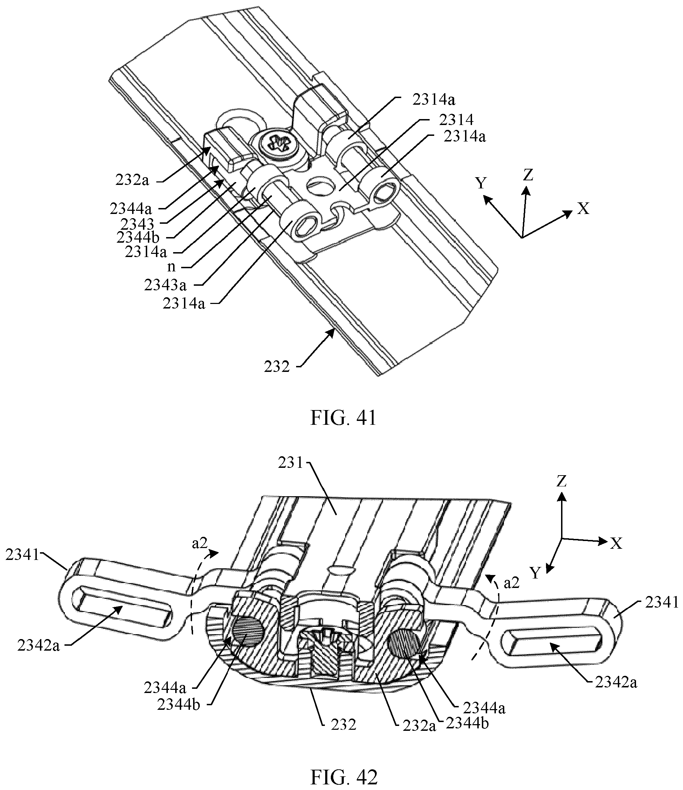

FIG. 40 is a schematic diagram of a structure of an area II in the rotating shaft mechanism 23 shown in FIG. 17. The door plate 235 is hidden in the figure. FIG. 41 is a schematic diagram of a structure of the rotating shaft mechanism 23 shown in FIG. 40 after a base body 2311 and a second swing arm 2341 are hidden. The rotating shaft base 231 further includes a third connecting piece 2314. The third connecting piece 2314 is fastened to the base body 2311.

In some embodiments, a shaft sleeve 2314a is disposed on the third connecting piece 2314, and a cylindrical shaft hole is disposed in the shaft sleeve 2314a. In some embodiments, there are four shaft sleeves 2314a. In the four shaft sleeves 2314a, two shaft sleeves 2314a located on the left and the two shaft sleeves 2313a on the left of the second connecting piece 2313 in the rotating shaft base 231 shown in FIG. 21 are coaxially disposed, and two shaft sleeves 2314a located on the right and the two shaft sleeves 2313a on the right of the second connecting piece 2313 in the rotating shaft base 231 shown in FIG. 21 are coaxially disposed.

On the foregoing basis, the second rotating shaft part 23b also includes a second swing arm 2341 and an actuating member 2343. The second swing arm 2341 and the actuating member 2343 in the second rotating shaft part 23b are respectively approximately the same as the second swing arm 2341 and the actuating member 2343 in the first rotating shaft part 23a. There are both two second swing arms 2341 and two actuating members 2343. In the two actuating members 2343, a rotating shaft part 2343a of an actuating member 2343 located on the left is sleeved in the two shaft sleeves 2314a located on the left of the third connecting piece 2314, and can rotate in the two shaft sleeves 2314a; and a rotating shaft part 2343a of an actuating member 2343 located on the right is sleeved in the two shaft sleeves 2314a located on the right of the third connecting piece 2314, and can rotate in the two shaft sleeves 2314a. A flat location n is disposed on a side surface of the rotating shaft part 2343a. A flat hole 2341a is disposed on the second swing arm 2341, and a shape and a size of the flat hole 2341a adapt to a shape of a cross section of the rotating shaft part 2343a. In the two second swing arms 2341, a second swing arm 2341 located on the left is disposed between the two shaft sleeves 2314a located on the left of the third connecting piece 2314, and is sleeved on the rotating shaft part 2343a of the actuating member 2343 on the left by using the flat hole 2341a; and a second swing arm 2341 located on the right is disposed between the two shaft sleeves 2314a located on the right of the third connecting piece 2314, and is sleeved on the rotating shaft part 2343a of the actuating member 2343 on the right by using the flat hole 2341a. Therefore, the actuating member 2343 is fastened relative to the second swing arm 2341.

A first sliding groove 2342a is disposed on the second swing arm 2341. On this basis, a first sliding member (not shown in the figure) is disposed on the middle frame, and the first sliding member is slidably connected in the first sliding groove 2342a.

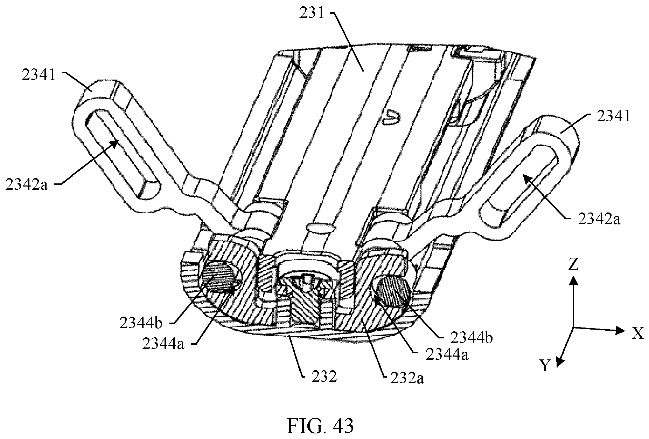

A lift slider 232a is disposed on the shaft cover 232, and a second sliding groove 2344a is disposed on the lift slider 232a. FIG. 42 is a schematic diagram of a cross-sectional structure of the rotating shaft mechanism 23 shown in FIG. 40 at a line E-E. In this accompanying drawing, the rotating shaft mechanism 23 is in the unfolded state. FIG. 43 is a schematic diagram of a structure of the rotating shaft mechanism 23 shown in FIG. 42 in a half folded state. An eccentric protrusion part (namely, the second sliding member 2344b) of the actuating member 2343 is disposed in the second sliding groove 2344a, and can slide along the second sliding groove 2344a.

In this way, when rotating from the unfolded location to the folded location, the first swing arm 233 in the first rotating shaft part 23a may drive the first sliding groove 2342a by using the first sliding member on the middle frame, so that the second swing arm 2341 in the second rotating shaft part 23b rotates in the direction a2. In a process in which the second swing arm 2341 rotates, the actuating member 2343 rotates with the second swing arm 2341, to further drive the second sliding groove 2344a by using the eccentric protrusion part, so as to drive the shaft cover 232 to move upward. On the contrary, when rotating from the folded location to the unfolded location, the first swing arm 233 in the first rotating shaft part 23a may drive the first sliding groove 2342a by using the first sliding member on the middle frame, so that the second swing arm 2341 in the second rotating shaft part 23b rotates in the direction opposite to the direction a2. In a process in which the second swing arm 2341 rotates, the actuating member 2343 rotates with the second swing arm 2341, to further drive the second sliding groove 2344a by using the eccentric protrusion part, so as to drive the shaft cover 232 to move downward.

Therefore, on the basis of disposing the first rotating shaft part 23a and the third rotating shaft part 23b, the second rotating shaft part 23b is further disposed, and the second rotating shaft part 23b is configured to provide an auxiliary support function for upward and downward movement of the shaft cover 232, so that all parts of the shaft cover 232 in a length direction of the shaft cover 232 can synchronously move upward and downward, thereby improving stability of upward and downward movement. In addition, a structure of the second rotating shaft part 23b is simple, so that structure complexity of the rotating shaft mechanism 23 can be reduced.

It can be learned that the second rotating shaft part 23b may have another structure form. For example, the structure form of the second rotating shaft part 23b is the same as the structure forms of the first rotating shaft part 23a and the third rotating shaft part 23b. This is not specifically limited in this application.

In the descriptions of this specification, specific features, structures, materials, or characteristics may be combined in any one or more embodiments or examples in a suitable manner.

Finally, it should be noted that the foregoing embodiments are only used to describe the technical solutions of this application, but are not used to limit this application. Although this application is described in detail with reference to the foregoing embodiments, it should be understood by a person of ordinary skill in the art that the technical solutions described in the foregoing embodiments may still be modified within the scope of the appended claims.

## Claims

1. A rotating shaft mechanism (23) for a foldable screen device, the rotating shaft mechanism comprising a rotating shaft base (231), a shaft cover (232), two first swing arms (233) symmetrically disposed on two opposite sides of the rotating shaft base (231), and two first drive mechanisms (234), wherein
the shaft cover (232) is located on a back side of the rotating shaft base (231), each first swing arm (233) is rotatably connected to the rotating shaft base (231), and each first swing arm (233) can rotate between an unfolded location and a folded location relative to the rotating shaft base (231), wherein the back side of the rotating shaft base is a side of the rotating shaft base (231) that is arranged so as to face away from a foldable screen of the foldable screen device; and
each first drive mechanism is connected between a respective one of the first swing arms (233) and the shaft cover (232), and when rotating from the unfolded location to the folded location, each first swing arm (233) drives, by using the first drive mechanism, the shaft cover (232) to move toward the rotating shaft base (231);
wherein a limiting structure (230) is disposed between the shaft cover (232) and the rotating shaft base (231), and the limiting structure (230) allows the shaft cover (232) to move toward or away from the rotating shaft base (231) in a thickness direction of the rotating shaft base (231), whereby the limiting structure (230) prevents the shaft cover (232) from moving along a plane perpendicular to the thickness direction of the rotating shaft base (231);
**characterised in that**:
each first drive mechanism comprises a respective second swing arm (2341);
each second swing arm (2341) is rotatably connected to the rotating shaft base (231), each first swing arm (233) is drivably connected to a respective one of the second swing arms (2341), and each second swing arm (2341) is drivably connected to the shaft cover (232);
each first swing arm (233) and the respective second swing arm (2341) are located on a same side of the rotating shaft base (231) such that a rotation direction of the second swing arm (2341) relative to the rotating shaft base (231) is the same as a rotation direction of the respective first swing arm (233) relative to the rotating shaft base (231); and
wherein each first drive mechanism is configured such that:
when rotating from the unfolded location to the folded location, the respective first swing arm (233) drives the respective second swing arm (2341) to rotate relative to the rotating shaft base (231), and further drives, by using the respective second swing arm (2341), the shaft cover (232) to move toward the rotating shaft base (231); and
when the respective first swing arm (233) rotates from the unfolded location to the folded location, an angle by which the respective first swing arm (233) drives the respective second swing arm (2341) to rotate relative to the rotating shaft base (231) is less than a rotation angle of the respective first swing arm (233) relative to the rotating shaft base (231).

2. The rotating shaft mechanism according to claim 1, wherein each first drive mechanism (234) comprises a first sliding groove (2342a) and a first sliding member (2342b), and, for each first drive mechanism:
one of the first sliding groove and the first sliding member is disposed on the respective first swing arm, the other of the first sliding groove and the first sliding member is disposed on the respective second swing arm, and the first sliding member is slidably connected in the first sliding groove; and
the respective first swing arm is drivably connected to the second swing arm by using a sliding pair formed by the first sliding groove and the first sliding member.

3. The rotating shaft mechanism according to claim 2, wherein, for each first drive mechanism (234):
rotation axes of the respective second swing arm (2341) and the respective rotating shaft base are a first axis;
the respective first sliding groove has a first end and a second end, and a distance from the first end to the first axis is less than a distance from the second end to the first axis; and
when the respective first swing arm is at the unfolded location, a vertical distance from the first end to a foldable screen is greater than a vertical distance from the second end to the foldable screen, and when the respective first swing arm rotates from the unfolded location to the folded location, the respective first sliding member slides from the first end to the second end along the respective first sliding groove.

4. The rotating shaft mechanism according to any one of claims 1-3, wherein each first drive mechanism further comprises an actuating member (2343); and
the actuating member is fastened relative to the respective second swing arm, and the respective second swing arm is drivably connected to the shaft cover by using the actuating member.

5. The rotating shaft mechanism according to claim 4, wherein a distance from an end part, that is on the respective second swing arm and that is drivably connected to the respective first swing arm, to a rotation center of the respective second swing arm is a first distance;
an end part that is on the actuating member and that is drivably connected to the shaft cover is eccentrically disposed relative to the rotation center of the respective second swing arm, and a distance from the end part, that is on the actuating member and that is drivably connected to the shaft cover, to the rotation center of the respective second swing arm is a second distance; and
the first distance is less than the second distance.

6. The rotating shaft mechanism according to claim 4 or 5, wherein each first drive mechanism further comprises a second sliding groove (2344a) and a second sliding member (2344b), and, for each first drive mechanism (234):
one of the second sliding groove and the second sliding member is disposed on the respective actuating member (2343), the other of the second sliding groove and the second sliding member is disposed on the shaft cover, and the second sliding member is slidably connected in the second sliding groove; and
the respective actuating member (2343) is drivably connected to the shaft cover by using a sliding pair formed by the second sliding groove and the second sliding member.

7. The rotating shaft mechanism according to any one of claims 1-6, further comprising two door plates (235) and two second drive mechanisms (236), wherein
each door plate is rotatably connected to a respective one of the first swing arms, and each second drive mechanism is connected between a respective one of the door plates and the rotating shaft base and, for each second drive mechanism:
when rotating from the unfolded location to the folded location, the respective first swing arm drives, by using the second drive mechanism, an end that is of the respective door plate and that is close to the rotating shaft base to tilt toward a side away from the foldable screen relative to an end that is of the respective door plate and that is away from the rotating shaft base.

8. The rotating shaft mechanism according to claim 7, wherein each second drive mechanism comprises a respective door plate swing arm (2361), and the door plate swing arm is rotatably connected to the rotating shaft base; and
a third sliding groove (2351 ) is disposed on the door plate, the door plate swing arm slidably penetrates into the third sliding groove, and when the respective first swing arm rotates from the unfolded location to the folded location, a rotation angle of the door plate swing arm relative to the rotating shaft base is greater than a rotation angle of the respective first swing arm relative to the rotating shaft base.

9. The rotating shaft mechanism according to any one of claims 1-6, wherein:
the rotating shaft mechanism further comprises a synchronization mechanism (237); and
the synchronization mechanism is connected between the two first swing arms, or the synchronization mechanism is connected between the second swing arms of the two first drive mechanisms.

10. The rotating shaft mechanism according to claim 9, wherein the synchronization mechanism comprises a drive slider (2371), and the drive slider is located between the second swing arms of the two first drive mechanisms;
the drive slider is slidably connected to the rotating shaft base in a length direction of the rotating shaft base, and the drive slider is drivably connected to the second swing arms of the two first drive mechanisms; and
when rotating from the unfolded location to the folded location, either of the second swing arms of the two first drive mechanisms drives the drive slider to slide in the length direction of the rotating shaft base, and drives the other of the second swing arms to synchronously rotate from the unfolded location to the folded location.

11. The rotating shaft mechanism according to claim 10, wherein one of a spiral sliding groove and a slider is disposed on the drive slider, and the other of the spiral sliding groove and the slider is disposed on the second swing arm; and
a center line of a spiral extension path of the spiral sliding groove is parallel to a slidable direction of the drive slider, and the slider is slidably disposed in the spiral sliding groove.

12. The rotating shaft mechanism according to claim 2, further comprising two damping mechanisms (238), wherein
each damping mechanism is disposed between a respective one of the first swing arms and the rotating shaft base, or between the first sliding groove and the first sliding member of a respective one of the first drive mechanisms, or the damping mechanism is disposed between a respective one of the second swing arms and the rotating shaft base.

13. The rotating shaft mechanism according to claim 12, wherein an end surface of the first sliding groove of each of the first drive mechanisms, in a length direction of the rotating shaft base, is a friction surface (2341c);
each damping mechanism is connected to a respective one of the first sliding members, and when sliding along the first sliding groove, the respective first sliding member drives the respective damping mechanism to move along the respective friction surface; and
each of the damping mechanisms comprises a respective friction member and a respective elastic member (2382), the friction member is located on a side faced by the respective friction surface, and the elastic member is configured to apply, to the respective friction member, elastic force pointing to the respective friction surface, so that the respective friction member abuts the respective friction surface.

14. A support apparatus, comprising a first housing, a second housing, and the rotating shaft mechanism according to any one of claims 1-13, wherein
the two first swing arms are respectively fastened to the first housing and the second housing.

15. A foldable screen device, comprising a foldable screen and the support apparatus according to claim 14, wherein
the foldable screen comprises a first display area, a second display area, and a third display area, the third display area is connected between the first display area and the second display area, the first display area is disposed on the first housing, the second display area is disposed on the second housing, and the third display area is disposed on the rotating shaft mechanism.

## Patentansprüche

1. Drehwellenmechanismus (23) für eine Faltbildschirmvorrichtung, wobei der Drehwellenmechanismus eine Drehwellenbasis (231), eine Wellenabdeckung (232), zwei erste Schwenkarme (233), die symmetrisch auf zwei gegenüberliegenden Seiten der Drehwellenbasis (231) angeordnet sind, und zwei erste Antriebsmechanismen (234) umfasst, wobei
sich die Wellenabdeckung (232) auf einer Rückseite der Drehwellenbasis (231) befindet, jeder erste Schwenkarm (233) drehbar mit der Drehwellenbasis (231) verbunden ist und sich jeder erste Schwenkarm (233) relativ zu der Drehwellenbasis (231) zwischen einer entfalteten Position und einer gefalteten Position drehen kann, wobei die Rückseite der Drehwellenbasis eine Seite der Drehwellenbasis (231) ist, die so angeordnet ist, dass sie von einem Faltbildschirm der Faltbildschirmvorrichtung abgewandt ist; und
jeder erste Antriebsmechanismus zwischen einem jeweiligen der ersten Schwenkarme (233) und der Wellenabdeckung (232) verbunden ist, und wenn er sich von der entfalteten Position in die gefaltete Position dreht, jeder erste Schwenkarm (233) unter Verwendung des ersten Antriebsmechanismus die Wellenabdeckung (232) dazu antreibt, sich in Richtung der Drehwellenbasis (231) zu bewegen;
wobei eine Begrenzungsstruktur (230) zwischen der Wellenabdeckung (232) und der Drehwellenbasis (231) angeordnet ist und die Begrenzungsstruktur (230) ermöglicht, dass sich die Wellenabdeckung (232) in einer Dickenrichtung der Drehwellenbasis (231) auf die Drehwellenbasis (231) zu oder von dieser weg bewegt, wodurch die Begrenzungsstruktur (230) verhindert, dass sich die Wellenabdeckung (232) entlang einer Ebene senkrecht zu der Dickenrichtung der Drehwellenbasis (231) bewegt;
**dadurch gekennzeichnet, dass**: jeder erste Antriebsmechanismus einen jeweiligen zweiten Schwenkarm (2341) umfasst;
jeder zweite Schwenkarm (2341) drehbar mit der Drehwellenbasis (231) verbunden ist, jeder erste Schwenkarm (233) antriebsmäßig mit einem jeweiligen der zweiten Schwenkarme (2341) verbunden ist und jeder zweite Schwenkarm (2341) antriebsmäßig mit der Wellenabdeckung (232) verbunden ist;
sich jeder erste Schwenkarm (233) und der jeweilige zweite Schwenkarm (2341) auf einer selben Seite der Drehwellenbasis (231) befinden, sodass eine Drehrichtung des zweiten Schwenkarms (2341) relativ zu der Drehwellenbasis (231) dieselbe ist wie eine Drehrichtung des jeweiligen ersten Schwenkarms (233) relativ zu der Drehwellenbasis (231); und
wobei jeder erste Antriebsmechanismus so eingerichtet ist, dass:
wenn er sich von der entfalteten Position in die gefaltete Position dreht, der jeweilige erste Schwenkarm (233) den jeweiligen zweiten Schwenkarm (2341) dazu antreibt, sich relativ zu der Drehwellenbasis (231) zu drehen, und ferner unter Verwendung des jeweiligen zweiten Schwenkarms (2341) die Wellenabdeckung (232) dazu antreibt, sich in Richtung der Drehwellenbasis (231) zu bewegen; und
wenn sich der jeweilige erste Schwenkarm (233) von der entfalteten Position in die gefaltete Position dreht, ein Winkel, um den der jeweilige erste Schwenkarm (233) den jeweiligen zweiten Schwenkarm (2341) dazu antreibt, sich relativ zu der Drehwellenbasis (231) zu drehen, kleiner ist als ein Drehwinkel des jeweiligen ersten Schwenkarms (233) relativ zu der Drehwellenbasis (231).

2. Drehwellenmechanismus nach Anspruch 1, wobei jeder erste Antriebsmechanismus (234) eine erste Gleitnut (2342a) und ein erstes Gleitelement (2342b) umfasst, und für jeden ersten Antriebsmechanismus:
eines von der ersten Gleitnut und dem ersten Gleitelement an dem jeweiligen ersten Schwenkarm angeordnet ist, das andere von der ersten Gleitnut und dem ersten Gleitelement an dem jeweiligen zweiten Schwenkarm angeordnet ist und das erste Gleitelement gleitbar in der ersten Gleitnut verbunden ist; und
der jeweilige erste Schwenkarm unter Verwendung eines durch die erste Gleitnut und das erste Gleitelement gebildeten Gleitpaars antriebsmäßig mit dem zweiten Schwenkarm verbunden ist.

3. Drehwellenmechanismus nach Anspruch 2, wobei für jeden ersten Antriebsmechanismus (234):
die Drehachse des jeweiligen zweiten Schwenkarms (2341) und der jeweiligen Drehwellenbasis eine erste Achse ist;
die jeweilige erste Gleitnut ein erstes Ende und ein zweites Ende aufweist und ein Abstand von dem ersten Ende zu der ersten Achse kleiner ist als ein Abstand von dem zweiten Ende zu der ersten Achse; und
wenn sich der jeweilige erste Schwenkarm in der entfalteten Position befindet, ein vertikaler Abstand von dem ersten Ende zu einem Faltbildschirm größer ist als ein vertikaler Abstand von dem zweiten Ende zu dem Faltbildschirm, und wenn sich der jeweilige erste Schwenkarm von der entfalteten Position in die gefaltete Position dreht, das jeweilige erste Gleitelement von dem ersten Ende zu dem zweiten Ende entlang der jeweiligen ersten Gleitnut gleitet.

4. Drehwellenmechanismus nach einem der Ansprüche 1 bis 3, wobei jeder erste Antriebsmechanismus ferner ein Betätigungselement (2343) umfasst; und
das Betätigungselement relativ zu dem jeweiligen zweiten Schwenkarm befestigt ist und der jeweilige zweite Schwenkarm unter Verwendung des Betätigungselements antriebsmäßig mit der Wellenabdeckung verbunden ist.

5. Drehwellenmechanismus nach Anspruch 4, wobei ein Abstand von einem Endteil, das sich an dem jeweiligen zweiten Schwenkarm befindet und das antriebsmäßig mit dem jeweiligen ersten Schwenkarm verbunden ist, zu einem Drehzentrum des jeweiligen zweiten Schwenkarms ein erster Abstand ist;
ein Endteil, das sich an dem Betätigungselement befindet und das antriebsmäßig mit der Wellenabdeckung verbunden ist, relativ zu dem Drehzentrum des jeweiligen zweiten Schwenkarms exzentrisch angeordnet ist und ein Abstand von dem Endteil, das sich an dem Betätigungselement befindet und das antriebsmäßig mit der Wellenabdeckung verbunden ist, zu dem Drehzentrum des jeweiligen zweiten Schwenkarms ein zweiter Abstand ist; und
der erste Abstand kleiner ist als der zweite Abstand.

6. Drehwellenmechanismus nach Anspruch 4 oder 5, wobei jeder erste Antriebsmechanismus ferner eine zweite Gleitnut (2344a) und ein zweites Gleitelement (2344b) umfasst, und für jeden ersten Antriebsmechanismus (234):
eines von der zweiten Gleitnut und dem zweiten Gleitelement an dem jeweiligen Betätigungselement (2343) angeordnet ist, das andere von der zweiten Gleitnut und dem zweiten Gleitelement an der Wellenabdeckung angeordnet ist und das zweite Gleitelement gleitbar in der zweiten Gleitnut verbunden ist; und
das jeweilige Betätigungselement (2343) unter Verwendung eines durch die zweite Gleitnut und das zweite Gleitelement gebildeten Gleitpaars antriebsmäßig mit der Wellenabdeckung verbunden ist.

7. Drehwellenmechanismus nach einem der Ansprüche 1 bis 6, ferner umfassend zwei Türplatten (235) und zwei zweite Antriebsmechanismen (236), wobei
jede Türplatte drehbar mit einem jeweiligen der ersten Schwenkarme verbunden ist und jeder zweite Antriebsmechanismus zwischen einer jeweiligen der Türplatten und der Drehwellenbasis verbunden ist, und für jeden zweiten Antriebsmechanismus:
wenn er sich von der entfalteten Position in die gefaltete Position dreht, der jeweilige erste Schwenkarm unter Verwendung des zweiten Antriebsmechanismus ein der Drehwellenbasis nahes Ende der jeweiligen Türplatte dazu antreibt, sich relativ zu einem von der Drehwellenbasis entfernten Ende der jeweiligen Türplatte zu einer von dem Faltbildschirm abgewandten Seite hin zu neigen.

8. Drehwellenmechanismus nach Anspruch 7, wobei jeder zweite Antriebsmechanismus einen jeweiligen Türplattenschwenkarm (2361) umfasst und der Türplattenschwenkarm drehbar mit der Drehwellenbasis verbunden ist; und
eine dritte Gleitnut (2351) an der Türplatte angeordnet ist, der Türplattenschwenkarm gleitbar in die dritte Gleitnut eindringt, und wenn sich der jeweilige erste Schwenkarm von der entfalteten Position in die gefaltete Position dreht, ein Drehwinkel des Türplattenschwenkarms relativ zu der Drehwellenbasis größer ist als ein Drehwinkel des jeweiligen ersten Schwenkarms relativ zu der Drehwellenbasis.

9. Drehwellenmechanismus nach einem der Ansprüche 1 bis 6, wobei:
der Drehwellenmechanismus ferner einen Synchronisationsmechanismus (237) umfasst; und
der Synchronisationsmechanismus zwischen den zwei ersten Schwenkarmen verbunden ist, oder der Synchronisationsmechanismus zwischen den zweiten Schwenkarmen der zwei ersten Antriebsmechanismen verbunden ist.

10. Drehwellenmechanismus nach Anspruch 9, wobei der Synchronisationsmechanismus einen Antriebsschieber (2371) umfasst und sich der Antriebsschieber zwischen den zweiten Schwenkarmen der zwei ersten Antriebsmechanismen befindet;
der Antriebsschieber in einer Längsrichtung der Drehwellenbasis gleitbar mit der Drehwellenbasis verbunden ist und der Antriebsschieber antriebsmäßig mit den zweiten Schwenkarmen der zwei ersten Antriebsmechanismen verbunden ist; und
wenn er sich von der entfalteten Position in die gefaltete Position dreht, jeder der zweiten Schwenkarme der zwei ersten Antriebsmechanismen den Antriebsschieber dazu antreibt, in der Längsrichtung der Drehwellenbasis zu gleiten, und den anderen der zweiten Schwenkarme dazu antreibt, sich synchron von der entfalteten Position in die gefaltete Position zu drehen.

11. Drehwellenmechanismus nach Anspruch 10, wobei eines von einer Spiralgleitnut und einem Schieber an dem Antriebsschieber angeordnet ist und das andere von der Spiralgleitnut und dem Schieber an dem zweiten Schwenkarm angeordnet ist; und
eine Mittellinie eines spiralförmigen Verlaufspfads der Spiralgleitnut parallel zu einer Gleitrichtung des Antriebsschiebers verläuft und der Schieber gleitbar in der Spiralgleitnut angeordnet ist.

12. Drehwellenmechanismus nach Anspruch 2, ferner umfassend zwei Dämpfungsmechanismen (238), wobei
jeder Dämpfungsmechanismus zwischen einem jeweiligen der ersten Schwenkarme und der Drehwellenbasis angeordnet ist, oder zwischen der ersten Gleitnut und dem ersten Gleitelement eines jeweiligen der ersten Antriebsmechanismen angeordnet ist, oder der Dämpfungsmechanismus zwischen einem jeweiligen der zweiten Schwenkarme und der Drehwellenbasis angeordnet ist.

13. Drehwellenmechanismus nach Anspruch 12, wobei eine Endfläche der ersten Gleitnut jedes der ersten Antriebsmechanismen in einer Längsrichtung der Drehwellenbasis eine Reibfläche (2341c) ist;
jeder Dämpfungsmechanismus mit einem jeweiligen der ersten Gleitelemente verbunden ist, und wenn es entlang der ersten Gleitnut gleitet, das jeweilige erste Gleitelement den jeweiligen Dämpfungsmechanismus dazu antreibt, sich entlang der jeweiligen Reibfläche zu bewegen; und
jeder der Dämpfungsmechanismen ein jeweiliges Reibelement und ein jeweiliges elastisches Element (2382) umfasst, sich das Reibelement auf einer Seite befindet, der die jeweilige Reibfläche zugewandt ist, und das elastische Element so eingerichtet ist, dass es eine zu der jeweiligen Reibfläche gerichtete elastische Kraft auf das jeweilige Reibelement ausübt, sodass das jeweilige Reibelement an der jeweiligen Reibfläche anliegt.

14. Stützvorrichtung, umfassend ein erstes Gehäuse, ein zweites Gehäuse und den Drehwellenmechanismus nach einem der Ansprüche 1 bis 13, wobei
die zwei ersten Schwenkarme jeweils an dem ersten Gehäuse und dem zweiten Gehäuse befestigt sind.

15. Faltbildschirmvorrichtung, umfassend einen Faltbildschirm und die Stützvorrichtung nach Anspruch 14, wobei
der Faltbildschirm einen ersten Anzeigebereich, einen zweiten Anzeigebereich und einen dritten Anzeigebereich umfasst, der dritte Anzeigebereich zwischen dem ersten Anzeigebereich und dem zweiten Anzeigebereich verbunden ist, der erste Anzeigebereich an dem ersten Gehäuse angeordnet ist, der zweite Anzeigebereich an dem zweiten Gehäuse angeordnet ist und der dritte Anzeigebereich an dem Drehwellenmechanismus angeordnet ist.

## Revendications

1. Mécanisme d'arbre rotatif (23) pour un dispositif à écran pliable, le mécanisme d'arbre rotatif comprenant une base d'arbre rotatif (231), un capot d'arbre (232), deux premiers bras oscillants (233) disposés symétriquement sur deux côtés opposés de la base d'arbre rotatif (231), et deux premiers mécanismes d'entraînement (234), dans lequel
le capot d'arbre (232) est situé sur un côté arrière de la base d'arbre rotatif (231), chaque premier bras oscillant (233) est relié de manière rotative à la base d'arbre rotatif (231), et chaque premier bras oscillant (233) peut tourner entre une position dépliée et une position pliée par rapport à la base d'arbre rotatif (231), dans lequel le côté arrière de la base d'arbre rotatif est un côté de la base d'arbre rotatif (231) qui est agencé de manière à être tourné à l'opposé d'un écran pliable du dispositif à écran pliable ; et
chaque premier mécanisme d'entraînement est relié entre l'un respectif des premiers bras oscillants (233) et le capot d'arbre (232), et lors de la rotation de la position dépliée vers la position pliée, chaque premier bras oscillant (233) amène, au moyen du premier mécanisme d'entraînement, le capot d'arbre (232) à se déplacer vers la base d'arbre rotatif (231) ;
dans lequel une structure de limitation (230) est disposée entre le capot d'arbre (232) et la base d'arbre rotatif (231), et la structure de limitation (230) permet au capot d'arbre (232) de se déplacer vers ou à l'opposé de la base d'arbre rotatif (231) dans une direction d'épaisseur de la base d'arbre rotatif (231), moyennant quoi la structure de limitation (230) empêche le capot d'arbre (232) de se déplacer le long d'un plan perpendiculaire à la direction d'épaisseur de la base d'arbre rotatif (231) ;
**caractérisé en ce que** : chaque premier mécanisme d'entraînement comprend un deuxième bras oscillant respectif (2341) ;
chaque deuxième bras oscillant (2341) est relié de manière rotative à la base d'arbre rotatif (231), chaque premier bras oscillant (233) est relié de manière motrice à l'un respectif des deuxièmes bras oscillants (2341), et chaque deuxième bras oscillant (2341) est relié de manière motrice au capot d'arbre (232) ;
chaque premier bras oscillant (233) et le deuxième bras oscillant respectif (2341) sont situés sur un même côté de la base d'arbre rotatif (231) de telle sorte qu'une direction de rotation du deuxième bras oscillant (2341) par rapport à la base d'arbre rotatif (231) est la même qu'une direction de rotation du premier bras oscillant respectif (233) par rapport à la base d'arbre rotatif (231) ; et
dans lequel chaque premier mécanisme d'entraînement est configuré de telle sorte que :
lors de la rotation de la position dépliée vers la position pliée, le premier bras oscillant respectif (233) amène le deuxième bras oscillant respectif (2341) à tourner par rapport à la base d'arbre rotatif (231), et amène en outre, au moyen du deuxième bras oscillant respectif (2341), le capot d'arbre (232) à se déplacer vers la base d'arbre rotatif (231) ; et
lorsque le premier bras oscillant respectif (233) tourne de la position dépliée vers la position pliée, un angle duquel le premier bras oscillant respectif (233) amène le deuxième bras oscillant respectif (2341) à tourner par rapport à la base d'arbre rotatif (231) est inférieur à un angle de rotation du premier bras oscillant respectif (233) par rapport à la base d'arbre rotatif (231).

2. Mécanisme d'arbre rotatif selon la revendication 1, dans lequel chaque premier mécanisme d'entraînement (234) comprend une première rainure de coulissement (2342a) et un premier élément coulissant (2342b), et, pour chaque premier mécanisme d'entraînement :
l'un de la première rainure de coulissement et du premier élément coulissant est disposé sur le premier bras oscillant respectif, l'autre de la première rainure de coulissement et du premier élément coulissant est disposé sur le deuxième bras oscillant respectif, et le premier élément coulissant est relié de manière coulissante dans la première rainure de coulissement ; et
le premier bras oscillant respectif est relié de manière motrice au deuxième bras oscillant au moyen d'une paire de coulissement formée par la première rainure de coulissement et le premier élément coulissant.

3. Mécanisme d'arbre rotatif selon la revendication 2, dans lequel, pour chaque premier mécanisme d'entraînement (234) :
l'axe de rotation du deuxième bras oscillant respectif (2341) et de la base d'arbre rotatif respective est un premier axe ;
la première rainure de coulissement respective présente une première extrémité et une deuxième extrémité, et une distance de la première extrémité au premier axe est inférieure à une distance de la deuxième extrémité au premier axe ; et
lorsque le premier bras oscillant respectif est à la position dépliée, une distance verticale de la première extrémité à un écran pliable est supérieure à une distance verticale de la deuxième extrémité à l'écran pliable, et lorsque le premier bras oscillant respectif tourne de la position dépliée vers la position pliée, le premier élément coulissant respectif coulisse de la première extrémité à la deuxième extrémité le long de la première rainure de coulissement respective.

4. Mécanisme d'arbre rotatif selon l'une quelconque des revendications 1 à 3, dans lequel chaque premier mécanisme d'entraînement comprend en outre un élément d'actionnement (2343) ; et
l'élément d'actionnement est fixé par rapport au deuxième bras oscillant respectif, et le deuxième bras oscillant respectif est relié de manière motrice au capot d'arbre au moyen de l'élément d'actionnement.

5. Mécanisme d'arbre rotatif selon la revendication 4, dans lequel une distance d'une partie d'extrémité, qui est sur le deuxième bras oscillant respectif et qui est reliée de manière motrice au premier bras oscillant respectif, à un centre de rotation du deuxième bras oscillant respectif est une première distance ;
une partie d'extrémité qui est sur l'élément d'actionnement et qui est reliée de manière motrice au capot d'arbre est disposée de manière excentrique par rapport au centre de rotation du deuxième bras oscillant respectif, et une distance de la partie d'extrémité, qui est sur l'élément d'actionnement et qui est reliée de manière motrice au capot d'arbre, au centre de rotation du deuxième bras oscillant respectif est une deuxième distance ; et
la première distance est inférieure à la deuxième distance.

6. Mécanisme d'arbre rotatif selon la revendication 4 ou 5, dans lequel chaque premier mécanisme d'entraînement comprend en outre une deuxième rainure de coulissement (2344a) et un deuxième élément coulissant (2344b), et, pour chaque premier mécanisme d'entraînement (234) :
l'un de la deuxième rainure de coulissement et du deuxième élément coulissant est disposé sur l'élément d'actionnement respectif (2343), l'autre de la deuxième rainure de coulissement et du deuxième élément coulissant est disposé sur le capot d'arbre, et le deuxième élément coulissant est relié de manière coulissante dans la deuxième rainure de coulissement ; et
l'élément d'actionnement respectif (2343) est relié de manière motrice au capot d'arbre au moyen d'une paire de coulissement formée par la deuxième rainure de coulissement et le deuxième élément coulissant.

7. Mécanisme d'arbre rotatif selon l'une quelconque des revendications 1 à 6, comprenant en outre deux volets (235) et deux deuxièmes mécanismes d'entraînement (236), dans lequel
chaque volet est relié de manière rotative à l'un respectif des premiers bras oscillants, et chaque deuxième mécanisme d'entraînement est relié entre l'un respectif des volets et la base d'arbre rotatif et, pour chaque deuxième mécanisme d'entraînement :
lors de la rotation de la position dépliée vers la position pliée, le premier bras oscillant respectif amène, au moyen du deuxième mécanisme d'entraînement, une extrémité du volet respectif qui est proche de la base d'arbre rotatif à s'incliner vers un côté à l'opposé de l'écran pliable par rapport à une extrémité du volet respectif qui est à l'opposé de la base d'arbre rotatif.

8. Mécanisme d'arbre rotatif selon la revendication 7, dans lequel chaque deuxième mécanisme d'entraînement comprend un bras oscillant de volet respectif (2361), et le bras oscillant de volet est relié de manière rotative à la base d'arbre rotatif ; et
une troisième rainure de coulissement (2351) est disposée sur le volet, le bras oscillant de volet pénètre de manière coulissante dans la troisième rainure de coulissement, et lorsque le premier bras oscillant respectif tourne de la position dépliée vers la position pliée, un angle de rotation du bras oscillant de volet par rapport à la base d'arbre rotatif est supérieur à un angle de rotation du premier bras oscillant respectif par rapport à la base d'arbre rotatif.

9. Mécanisme d'arbre rotatif selon l'une quelconque des revendications 1 à 6, dans lequel :
le mécanisme d'arbre rotatif comprend en outre un mécanisme de synchronisation (237) ; et
le mécanisme de synchronisation est relié entre les deux premiers bras oscillants, ou le mécanisme de synchronisation est relié entre les deuxièmes bras oscillants des deux premiers mécanismes d'entraînement.

10. Mécanisme d'arbre rotatif selon la revendication 9, dans lequel le mécanisme de synchronisation comprend un coulisseau d'entraînement (2371), et le coulisseau d'entraînement est situé entre les deuxièmes bras oscillants des deux premiers mécanismes d'entraînement ;
le coulisseau d'entraînement est relié de manière coulissante à la base d'arbre rotatif dans une direction de longueur de la base d'arbre rotatif, et le coulisseau d'entraînement est relié de manière motrice aux deuxièmes bras oscillants des deux premiers mécanismes d'entraînement ; et
lors de la rotation de la position dépliée vers la position pliée, l'un ou l'autre des deuxièmes bras oscillants des deux premiers mécanismes d'entraînement amène le coulisseau d'entraînement à coulisser dans la direction de longueur de la base d'arbre rotatif, et amène l'autre des deuxièmes bras oscillants à tourner de manière synchrone de la position dépliée vers la position pliée.

11. Mécanisme d'arbre rotatif selon la revendication 10, dans lequel l'un d'une rainure de coulissement en spirale et d'un coulisseau est disposé sur le coulisseau d'entraînement, et l'autre de la rainure de coulissement en spirale et du coulisseau est disposé sur le deuxième bras oscillant ; et
une ligne médiane d'un trajet d'extension en spirale de la rainure de coulissement en spirale est parallèle à une direction de coulissement du coulisseau d'entraînement, et le coulisseau est disposé de manière coulissante dans la rainure de coulissement en spirale.

12. Mécanisme d'arbre rotatif selon la revendication 2, comprenant en outre deux mécanismes d'amortissement (238), dans lequel
chaque mécanisme d'amortissement est disposé entre l'un respectif des premiers bras oscillants et la base d'arbre rotatif, ou entre la première rainure de coulissement et le premier élément coulissant de l'un respectif des premiers mécanismes d'entraînement, ou le mécanisme d'amortissement est disposé entre l'un respectif des deuxièmes bras oscillants et la base d'arbre rotatif.

13. Mécanisme d'arbre rotatif selon la revendication 12, dans lequel une surface d'extrémité de la première rainure de coulissement de chacun des premiers mécanismes d'entraînement, dans une direction de longueur de la base d'arbre rotatif, est une surface de frottement (2341c) ;
chaque mécanisme d'amortissement est relié à l'un respectif des premiers éléments coulissants, et lors du coulissement le long de la première rainure de coulissement, le premier élément coulissant respectif amène le mécanisme d'amortissement respectif à se déplacer le long de la surface de frottement respective ; et
chacun des mécanismes d'amortissement comprend un élément de frottement respectif et un élément élastique respectif (2382), l'élément de frottement est situé sur un côté auquel fait face la surface de frottement respective, et l'élément élastique est configuré pour appliquer, à l'élément de frottement respectif, une force élastique dirigée vers la surface de frottement respective, de sorte que l'élément de frottement respectif vienne en butée contre la surface de frottement respective.

14. Appareil de support, comprenant un premier boîtier, un deuxième boîtier et le mécanisme d'arbre rotatif selon l'une quelconque des revendications 1 à 13, dans lequel
les deux premiers bras oscillants sont respectivement fixés au premier boîtier et au deuxième boîtier.

15. Dispositif à écran pliable, comprenant un écran pliable et l'appareil de support selon la revendication 14, dans lequel
l'écran pliable comprend une première zone d'affichage, une deuxième zone d'affichage et une troisième zone d'affichage, la troisième zone d'affichage est reliée entre la première zone d'affichage et la deuxième zone d'affichage, la première zone d'affichage est disposée sur le premier boîtier, la deuxième zone d'affichage est disposée sur le deuxième boîtier, et la troisième zone d'affichage est disposée sur le mécanisme d'arbre rotatif.
